# EUROPEAN PATENT SPECIFICATION

(11) **EP 3 192 108 B1**
(45) Date of publication and mention of the grant of the patent: **27.03.2019**
(21) Application number: 15840000.2
(22) Date of filing: 01.06.2015
(51) Int. Cl.: H01L 51/30

(54) **USE OF AMBIENT-ROBUST SOLUTION PROCESSING FOR PREPARING NANOSCALE ORGANIC FERROELECTRIC FILMS**
VERWENDUNG VON UMGEBUNGSROBUSTER LÖSUNGSVERARBEITUNG ZUR HERSTELLUNG VON NANOSKALIGEN ORGANISCHEN FERROELEKTRISCHEN FILMEN
UTILISATION DE TRAITEMENT DE SOLUTION ROBUSTE DANS L'AIR AMBIANT DESTINÉ À PRÉPARER DES FILMS FERROÉLECTRIQUES ORGANIQUES À L'ÉCHELLE NANOMÉTRIQUE

(30) Priority: 12.09.2014 US 201462049717 P
(43) Date of publication of application: 19.07.2017
(73) Proprietor: SABIC Global Technologies B.V., 4612 PX Bergen op Zoom (NL)
(72) Inventor: PARK, Ji, Hoon, Thuwal 23955-6900 (SA); ALSHAREEF, Husam, N., Thuwal 23955-6900 (SA); ODEH, Ihab, N., Sugar Land, TX 77478 (US)
(74) Representative: Patentanwälte Bressel und Partner mbB
(86) International application number: PCT/US2015/033547
(87) International publication number: WO 2016/039830

(56) References cited:
- WO-A1-2011/078791
- WO-A1-2012/079231
- WO-A2-2014/130431
- US-A1- 2004 131 862
- US-A1- 2009 263 671
- US-A1- 2010 215 836
- US-B1- 6 440 591
- US-B2- 6 734 478
- US-B2- 7 214 410

## Description

### CROSS REFERENCE TO RELATED APPLICATIONS

### BACKGROUND OF THE INVENTION

### A. Field of the Invention

The invention generally concerns the preparation of organic ferroelectric thin films under ambient or room temperature conditions. The process parameters include depositing a heated solution (at least 75 °C to the boiling point of the solvent) comprising an organic ferroelectric polymer and a solvent onto a substrate in an amount sufficient to produce ferroelectric films having a thickness of 400 nm or less. The resulting thin films have improved surface morphologies (e.g., reduced surface roughness) when compared with thin films prepared with heated solutions having a temperature of less than 75 °C, as well as with thin films having thicknesses of greater than 400 nm.

### B. Description of Related Art

Memory systems are used for storage of data, program code, and/or other information in many electronic products, such as personal computer systems, embedded processor-based systems, video image processing circuits, portable phones, and the like. Important characteristics for a memory cell in electronic device are low cost, nonvolatility, high density, writability, low power, and high speed. Conventional memory solutions include Read Only Memory (ROM), Programmable Read only Memory (PROM), Electrically Programmable Memory (EPROM), Electrically Erasable Programmable Read Only Memory (EEPROM), Dynamic Random Access Memory (DRAM) and Static Random Access Memory (SRAM).

### CROSS REFERENCE TO RELATED APPLICATIONS

More recently, ferromagnetic RAM (FRAM) has been attempted. FRAM utilizes a ferromagnetic region or film of a ferroelectric capacitor, thin film transistor, or diode to generate a nonvolatile memory cell. Such electronic devices are fabricated using two parallel conductive plates separated by a ferroelectric polymer layer. The ferroelectric polymer layer is a layer of insulating film which contains a permanent electrical polarization that can be reversed repeatedly, by an opposing electric field. As a result, the ferroelectric capacitor, thin film transistor, or diode has two possible non-volatile states, which they can retain without electrical power, corresponding to the two binary logic levels in a digital memory. Additionally, ferroelectric capacitors, transistors, and diodes also provide energy-storing functionality. When a voltage is applied across the plates, the electric field in the ferroelectric material displaces electric charges, and thus stores energy. The amount of energy stored depends on the dielectric constant of the insulating material and the dimensions (total area and thickness) of the film.

Typically, poly(vinylidene fluoride) (PVDF) type polymers or copolymers (e.g., a copolymer of PVDF with trifluoroethylene (TrFe) (PVDF-TrFe)) are used as the ferroelectric material due to their large polarization values and electrical and material properties. PVDF type polymers are attractive for electronic devices as they can be produced in the form of films and in a variety of shapes, have high chemical resistance, and high efficiency in converting mechanical energy to electrical energy. PVDF has five different polymorphs (also referred to as phases), alpha (α), beta (β), gamma (γ), delta (δ) and epsilon (ε), with the most common of the polymorphs being the alpha (α) polymorph. The alpha polymorph demonstrates little to no ferroelectric properties, while the remaining phases demonstrate stronger ferroelectric properties, with the beta-polymorph being most preferred.

Many attempts have been made to transform the alpha-polymorph to the more desirable beta-polymorph using various processing conditions such as solution processing, melt processing, or mechanical processing. These methods suffer as they have only been able to prepare PVDF-type polymer films having a thickness of several microns (for example, greater than 1,000 nanometer (nm)), which are less suitable for use in microelectronic devices. The development of nanoscale films has been difficult because thin films are more prone to breakdown under a high electric field. Current technologies use evaporative deposition methods, such as thermal vapor deposition, ionized vapor deposition, electric-field assisted vapor deposition, low pressure chemical vapor deposition, or the like to prepare nanoscale films. While these types of methods can form the beta-polymorph on the substrate, the conditions used in the evaporation processes (for example, temperatures of about 350 °C) tend to cause reduction in molecular weight, crystallinity, and, thus a reduction in ferroelectric and optical properties.

Other attempts to produce ferroelectric films include processing of polymeric solutions at temperatures of less than 80 °C to inhibit crystallization of the polymer in the alpha-polymorph. These methods typically produce films having a thickness of greater than 1 micron with a series of topographic formations manifested on the surface of the polymeric layer (*See,* for example, Ramasundaram et al., Macromolecular Chemistry and Physics, 2008, Vol. 209, 2516-2526 and Ramasundaram et al., Macromolecular Chemistry and Physics, 2009, Vol. 210, 951-960). These topographic formations can make the surface rough, and thus less suitable for use with some substrates and can also affect the ferroelectric properties of the film.

Cardoso et al. in Smart Materials and Structures, 2011, Vol. 20, pp. describes a method of producing ferroelectric films of 300 nm or more by thermal annealing directly after deposition under ambient conditions. Thin films produced from this method crystallized as a porous film, which resulted in poor electronic properties.

Li et al., in J. Material Chem. C., 2013, Vol. 1, pp. 7695-7702 describes preparation of PVDF films using wire-bar coating techniques that have a thickness of greater than 1 micron (1,000 nm) by controlling the substrate temperature and the relative humidity of process. This process, however, resulted in films having an alpha-polymorph, which required further processing to convert the alpha-polymorph to a ferroelectric polymorph. Li et al., in Applied Physics Letters, 2013, Vol. 103, pp. 072903-4 describes preparation of smooth alpha PVDF thin films using spin-coating techniques by controlling the solid weight content or spinning speed of the process. The smooth alpha PVDF films are converted to delta PVDF using electrical impulses.

Other attempts to produce thin PVDF films include addition of additives such as polymethylmethacrylate or metal ions. While attempts have been made to make thin films of PVDF, these films suffer from the having rough surfaces and poor optical properties, which make them ineffective for use in micro-electric devices.

US-A-2004/131862) discloses ferroelectric films comprising PVDF applied on pairs of surface electrodes.

WO 2011/078791 discloses the heating of VDF oligomer solutions to 55°C before deposition to form a film of PVDF.

WO 2012/079231 discloses solubilisation of PVDF polymers in DMSO by heating.

### SUMMARY OF THE INVENTION

A solution to the problems associated with producing thin organic ferroelectric polymer films having ferroelectric hysteresis properties with desired optical properties and surface roughness morphologies has been discovered. The solution resides in heating a composition (e.g., solution) of solvent with an organic ferroelectric polymer solubilized therein to a temperature greater than 75 °C and less than the boiling point of the solvent. The heated composition can then be deposited onto a substrate under ambient or room temperature conditions and further processed to produce a ferroelectric film having ferroelectric hysteresis properties and a thickness of 400 nm or less. Notably, it was discovered that the combination of heating the composition and the thickness of the resulting film being 400 nm or less produced films having the desired ferroelectric hysteresis properties, surface roughness morphologies, and optical qualities. Without wishing to be bound by theory, it is believed that the heating step reduces the influx of water into the composition (e.g., by diffusion of humidity into the composition) during processing, thereby reducing the likelihood of phase separation of the organic ferroelectric polymer from the solvent (water is a non-solvent to a PVDF-based polymer). Phase separation is believed to increase the surface roughness of the film-during annealing, the water molecules in the film move through the polymer matrix to the surface of the film and into the atmosphere, which produces topographic formations on the surface of the film. Topographic formations with a sufficient height can cause the surface of the film to be rough and hazy/reduced transparency. Maintaining the thickness of the resulting film to 400 nm or less is believed to contribute to/benefit the optical qualities of the film by increasing its transparency. Therefore, the combination of the heated composition with the resulting film thickness results in a process that can be performed under ambient processing conditions, the result of which is the production of nanoscale ferroelectric films having desired ferroelectric hysteresis properties, surface roughness morphologies, and optical qualities.

Notably, the process of the present invention does not require a humidity- and/or temperature-controlled environment and does not require the use of non-ferroelectric polymers to be blended with the composition (e.g., poly-(methyl methacrylate) (PMMA)), electrical poling, controlling of the cooling and heating rates during annealing, and/or the use of additives. This contributes to the elegance of the process of the present invention as well as increasing the process's efficiency with respect to production costs and complexities when compared with known processes currently used to produce ferroelectric films.

In one aspect of the present invention, there is disclosed a method for preparing a ferroelectric film having ferroelectric hysteresis properties. The method includes obtaining a composition comprising a solvent and an organic ferroelectric polymer solubilized therein, heating the composition to above 75 °C and below the boiling point of the solvent, depositing the heated composition onto a substrate, and annealing the heated composition to form a ferroelectric film having ferroelectric hysteresis properties and a thickness of 400 nm or less. The composition can be a solution, a gel, or a melt, and is preferably a solution. Solution-based deposition techniques are particularly preferred (e.g., spin coating process, a wire-bar coating process, a doctor-blading process, or a roll to roll process), with spin coating being particularly preferred. Additional coating processes such as spray coating, ultrasonic spray coating, ink-jet printing, screen printing, drop casting, dip coating, Mayer rod coating, gravure coating, slot die coating, extrusion coating, etc. can also be used. In some instances, the thickness of the produced ferroelectric film is less than 400 nm, less than 375 nm, less than 350 nm, less than 300 nm, less than 275 nm, less than 250 nm, less than 225 nm, less than 200 nm, less than 175 nm, less than 150 nm, less than 125 nm, less than 100 nm. In more preferred aspects, the thickness of the resulting film is 10 nm to 400 nm, preferably 140 nm to 300 nm, and most preferably from 200 nm to 300 nm. The temperature of the heated composition while being deposited onto a substrate is greater 75 °C, greater than 80 °C, greater than 85 °C, greater than 90 °C, greater than 95 °C, greater than 100 °C, greater than 125 °C, greater than 150 °C, greater than 175 °C. In more preferred aspects, the temperature of the heated composition during deposition onto the substrate is greater than 75 °C to 200 °C, preferably above 75 °C to 150 °C, and most preferably from 80 °C to 120 °C. In one embodiment, the surface roughness of the resulting film can be 20 nm or less, as determined by atomic force microscopy (AFM) using the procedure described in Li et al., in J. Material Chem. C., 2013, Vol. 1, pp. 7695-7702. In some aspects of the invention, the produced thin organic ferroelectric film can have high quality optical properties (for example, be transparent). The film is transparent as demonstrated by having an absorbance (interference fringes) between the wavelengths of 300 to 1000 nm of 10⁻¹ a.u. or less when plotted in double-logarithmic scale. The heated composition can include a sufficient amount of the ferroelectric polymer solubilized in the solvent to achieve a desired ferroelectric hysteresis property. In one preferred aspect, the amount includes 3 wt. % to about 12 wt. % of the organic ferroelectric polymer based on the total weight of the composition. However, amounts below 3 wt. % and above 12 wt.% can also be used. Non-limiting examples of organic ferroelectric polymers that can be used in the context of the present invention are provided in the detailed description, which is incorporated into this section by reference. Preferred organic ferroelectric polymers include poly(vinylidene fluoride) (PVDF) and poly(vinylidene fluoride-tetrafluoroethylene) (PVDF-TrFE), or a blend or mixture thereof.

Another aspect of the present invention is the ability to tune the surface morphology and transparency of the produced films. In one instance, there is disclosed a method for controlling the surface roughness of a ferroelectric film having ferroelectric hysteresis properties. The method can include (a) reducing the amount of water diffusing into a composition comprising a solvent and an organic ferroelectric polymer solubilized therein by heating the composition to a targeted temperature range that is above room temperature and below the boiling point of the solvent, wherein the targeted temperature range corresponds to a targeted surface morphology of the ferroelectric film, (b) depositing the heated composition onto a substrate, and (c) annealing the heated composition to form a ferroelectric film having ferroelectric hysteresis properties, a thickness of 400 nanometers or less, and the targeted surface morphology. As explained above, it is believed that when the temperature of the composition during deposition onto the substrate is less than 75 °C, the composition absorbs a substantial amount of water from the external environment (e.g., water vapor from air/diffusion of humidity into the composition). This water is typically immiscible in the solvent, thereby causing phase separation of the solvent/organic ferroelectric polymer. During annealing, the water molecules move through the composition into the atmosphere, which produces topographic formations on the resulting surface of the film. Topographic formations with a sufficient height can cause the surface of the film to be rough. A rough surface can make the film less transparent (i.e., images viewed through the film appear hazy). Therefore, ferroelectric films made by the processes of the present invention can be tuned to have a desired surface roughness or a desired transparency by controlling the temperature of the heated composition. In some instances, it may be desirable to have a larger surface roughness value (as determined by AFM) where the underlying substrate is difficult to attach or adhere a film to (e.g., increasing surface roughness can increase adhesion due to an increase in surface area). Conversely, it may be desirable to have a lower AFM value in instances where the substrate is more amenable to adherence of a ferroelectric film. In either instance, the surface roughness or morphology of the films of the present invention can be tuned or controlled as desired. Still further, varying the thickness or amount of the organic ferroelectric film can also be used to further tune the thickness and optical properties of the resulting films.

In yet another aspect of the present invention, there is disclosed a ferroelectric device produced by the processes of the present invention. The ferroelectric device includes, but is not limited to, a ferroelectric capacitor, thin film capacitor, or a diode. The ferroelectric device includes a first conductive material and a second conductive material. At least a portion of the organic ferroelectric film is disposed between at least a portion of the first conductive material and at least a portion of the second conductive material. The ferroelectric device can be comprised on any type of substrate (e.g., polymeric, inorganic, organic, etc.) known to those of ordinary skill in the art. Some non-limiting examples include silicon substrates, plastic substrates, paper substrates, etc.

Still further, the thin organic ferroelectric films produced by the methods described herein or ferroelectric devices comprising said films can be used in an electronic device, a printed circuit board or an integrated circuit. For example, the ferroelectric device of the present invention can be included in at least a portion of a communications circuit, a sensing circuit, or a control circuit of the electronic device, the printed circuit board or the integrated circuit. The circuit can be a piezoelectric sensor, piezoelectric transducer, piezoelectric actuator, a pyroelectric sensor, a pyroelectric sensor, a pyroelectric transducer, or a pyroelectric actuator. Further, electronic devices comprising the ferroelectric film or the ferroelectric device of the present invention are also contemplated.

In a further embodiment of the present invention there is disclosed a method of decoupling a circuit from a power supply with a ferroelectric device of the present invention. The method can include disposing the ferroelectric device between a power voltage line and a ground voltage line, wherein the ferroelectric device is coupled to the power voltage line and to the ground voltage line, and wherein a reduction in power noise generated by the power voltage and the ground voltage is achieved.

Also disclosed is a method for operating an energy storage circuit that includes a ferroelectric device of the present invention, which provides electrical power to a consuming device when electrical power from a primary source is unavailable. The method can include: (1) defining a target energy level for the ferroelectric device, wherein the target energy level is based on a selected material weight percentage of the second polymer in the ferroelectric film; (2) charging the device; (3) measuring a first amount of energy that is stored in the ferroelectric device during charging; (4) terminating charging of the ferroelectric device when the first amount of energy stored in the device reaches the target energy level; and (5) discharging the device into the consuming device, such as when electrical power from the primary source becomes unavailable.

In another aspect of the invention a method of operating a piezoelectric sensor, a piezoelectric transducer, or a piezoelectric actuator using the ferroelectric device of the present invention is disclosed. In some aspects of the invention, a method of operating a pyroelectric sensor, a pyroelectric transducer, or a pyroelectric actuator using the ferroelectric device of the present invention is disclosed. Examples of pyroelectric sensors include a passive infra-red detector, an infra-red imaging array, and a fingerprint sensor.

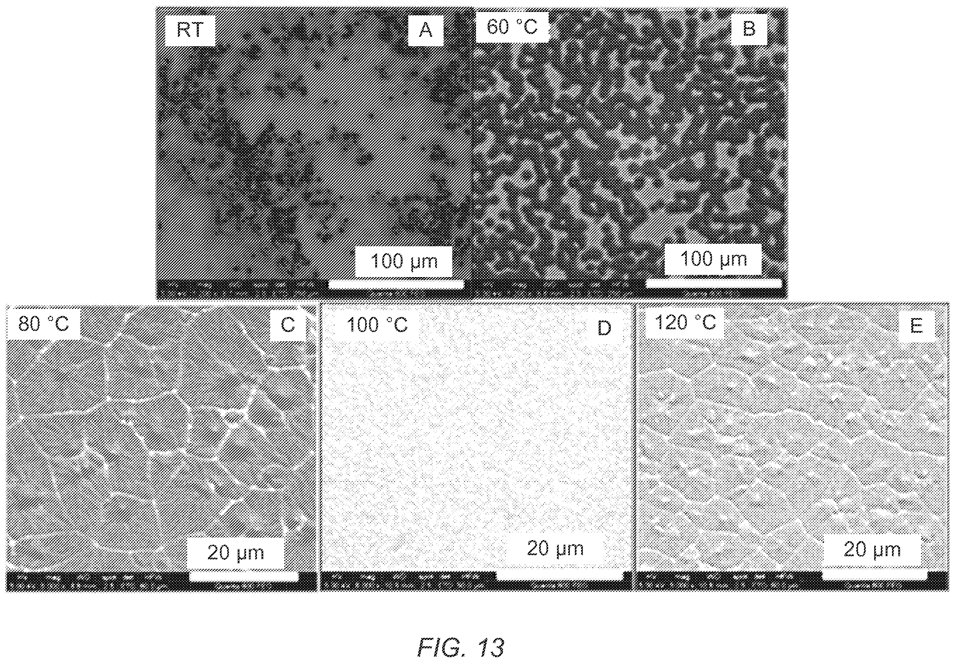

In still another aspect of the present invention there is disclosed a ferroelectric film having ferroelectric hysteresis properties, the film comprising an organic ferroelectric polymer, a thickness of 400 nm or less, and a smooth surface morphology (e.g., 20 nm or less, or 1 nm to 20 nm, or preferably 5 nm to 20 nm, or most preferably 10 nm to 20 nm, as determined by Atomic Force Microscopy (AFM)). The ferroelectric film can have a thickness of 350 nm or less, 300 nm, or less, 10 nm to 400 nm, preferably 140 nm to 300 nm, and most preferably from 200 nm to 300 nm. The ferroelectric film can have a surface morphology as substantially depicted in FIG. 13C, FIG. 13D, or FIG. 13E. The film can be transparent. Transparency can be determined such that the film has an absorbance between the wavelengths of 300 to 1000 nm of 10⁻¹ a.u. or less. The organic ferroelectric polymer can be those disclosed throughout the specification and claims (e.g., polyvinylidene fluoride (PVDF)-based polymer, a polyundecanoamide (Nylon 11)-based polymer, or a blend thereof). By way of example, the PVDF-based polymer can be a homopolymer, a copolymer, or a terpolymer, or a blend thereof. The PVDF-based polymer can be blended with a non-PVDF-based polymer. The non-PVDF polymer can be a poly(phenylene oxide) (PPO) polymer, a polystyrene (PS) polymer, or a poly(methyl methacrylate) (PMMA) polymer, or a blend thereof. The PVDF-based polymer can be PVDF, a poly(vinylidene fluoride-tetrafluoroethylene) (PVDF-TrFE), or a poly(vinylidene-fluoride-co-hexafluoropropene) (PVDF-HFP), poly(vinylidene fluoride-co-chlorotrifluoroethylene) (PVDF-CTFE), poly(vinylidene fluoride-co-chlorofluoroethylene) (PVDF-CFE), poly(vinylidene fluoride-co-chlorodifluoroethylene) (PVDF-CDFE), poly(vinylidene fluoride-co-trifluoroethylene-co-chlorofluoroethylene) (PVDF-TrFE-CFE), poly(vinylidene fluoride-co-trifluoroethylene-co-chlorotrifluoroethylene) (PVDF-TrFE-CTFE), poly(vinylidene fluoride-co-trifluoroethylene-co- hexafluoropropylene) (PVDF-TrFE-HFP), poly(vinylidene fluoride-co-trifluoroethylene-co- chlorodifluoroethylene) (PVDF-TrFE-CDFE), poly(vinylidene fluoride-co-tetrafluoroethylene- co-chlorofluoroethylene) (PVDF-TFE-CFE), poly(vinylidene fluoride-co-tetrafluoroethylene- co-chlorotrifluoroethylene) (PVDF-TFE-CTFE), poly(vinylidene fluoride-co- tetrafluoroethylene-co- hexafluoropropylene) (PVDF-TFE-HFP), and poly(vinylidene fluoride- co-tetrafluoroethylene-co- chlorodifluoroethylene) (PVDF-TFE-CD FE), or a polymeric blend thereof. In preferred embodiments, the PVDF-based polymer can be PVDF or a blend comprising PVDF. The film can have PVDF in a beta (β), gamma (γ), delta (δ), or epsilon (ε), preferably a beta (β) phase or a gamma (γ) phase, most preferably a gamma (γ) phase. In certain aspects, the film does not include a metal alkoxide. The film can be comprised in an electronic device, printed circuit board, or integrated circuit. The film can be comprised in a ferroelectric capacitor, a thin film transistor, or a diode. The film can be comprised in a device, non-limiting examples of which include a smartcard, a RFID card or tag, a piezoelectric sensor, a piezoelectric transducer, a piezoelectric actuator, a pyroelectric sensor, a memory device, a non-volatile memory cell, a standalone memory cell, a firmware, a microcontroller, a gyroscope, an acoustics sensor, an actuator, a micro-generator, a power supply circuit, a circuit coupling and decoupling device, a radio frequency filtering device, a delay circuit, a radio frequency tuner, a passive infra-red sensor, an infrared imaging array, or a fingerprint sensor).

Also disclosed in the context of the present invention are embodiments 1 to 79. Embodiment 1 is a method for preparing a ferroelectric film having ferroelectric hysteresis properties. The method can include (a) obtaining a composition comprising a solvent and an organic ferroelectric polymer solubilized therein; (b) heating the composition to above 75 °C and below the boiling point of the solvent; (c) depositing the heated composition onto a substrate; and (d) annealing the heated composition to form a ferroelectric film having ferroelectric hysteresis properties and a thickness of 400 nm or less. Embodiment 2 is the method of embodiment 1, wherein the thickness of the ferroelectric film is 350 nm or less, 300 nm, or less, 10 nm to 400 nm, preferably 140 nm to 300 nm, and most preferably from 200 nm to 300 nm. Embodiment 3 is the method of embodiment 2, wherein the composition is heated to above 75 °C to 200 °C, preferably above 75 °C to 150 °C, and most preferably from 80 °C to 120 °C. Embodiment 4 is the method of embodiment 3, wherein the ferroelectric polymer is polyvinylidene fluoride (PVDF) or a blend thereof. Embodiment 5 is the method of any one of embodiments 1 to 4, wherein the surface morphology of the film is smooth. Embodiment 6 is the method of embodiment 5, wherein the film has a surface roughness of 20 nm or less as determined by Atomic Force Microscopy (AFM). Embodiment 7 is the method of any one of embodiments 1 to 6, wherein the composition is a solution, a gel, or a melt. Embodiment 8 is the method of embodiment 7, wherein the composition is a solution. Embodiment 9 is the method of any one of embodiments 1 to 8, wherein the composition comprises about 3 wt. % to about 12 wt. % of the organic ferroelectric polymer. Embodiment 10 is the method of any one of embodiments 1 to 9, wherein the substrate comprises a lower electrode, and wherein the heated solution is deposited on the lower electrode. Embodiment 11 is the method of embodiment 10, further comprising depositing an upper electrode on the ferroelectric film. Embodiment 12 is the method of any one of embodiments 1 to 11, wherein the solvent comprises dimethylformamide, dimethyl acetate, dimethylacetamide, tetramethyl urea, dimethyl sulfoxide, trimethyl phosphate, N-methyl-2-pyrrolidone, diethyl carbonate, or any combination thereof. Embodiment 13 is the method of any one of embodiments 1 to 12, wherein the temperature in step (b) is sufficient to overcome or prevent the diffusion of humidity from an ambient environment. Embodiment 14 is the method of any one of embodiments 1 to 13, wherein depositing the composition in step (c) is performed at a relative humidity of 50% or less. Embodiment 15 is the method of any one of embodiments 1 to 14, wherein the film has an absorbance between the wavelengths of 300 to 1000 nm of 10-1 a.u. or less. Embodiment 16 is the method of any one of embodiments 1 to 3 or 5 to 15, wherein the organic ferroelectric polymer is a polyvinylidene fluoride (PVDF)-based polymer, a polyundecanoamide (Nylon 11)-based polymer, or a blend thereof. Embodiment 17 is the method of embodiment 16, wherein the PVDF-based polymer is a homopolymer, a copolymer, or a terpolymer, or a blend thereof. Embodiment 18 is the method of any of one of embodiments 16 to 17, wherein the PVDF-based polymer is blended with a non-PVDF-based polymer. Embodiment 19 is the method of embodiment 18, wherein the non-PVDF polymer is a poly(phenylene oxide) (PPO) polymer, a polystyrene (PS) polymer, or a poly(methyl methacrylate) (PMMA) polymer, or a blend thereof. Embodiment 20 is the method of any of one of embodiments 16 to 19, wherein the PVDF-based polymer is PVDF, a poly(vinylidene fluoride-tetrafluoroethylene) (PVDF-TrFE), or a poly(vinylidene-fluoride-co-hexafluoropropene) (PVDF-HFP), poly(vinylidene fluoride-co-chlorotrifluoroethylene) (PVDF-CTFE), poly(vinylidene fluoride-co-chlorofluoroethylene) (PVDF-CFE), poly(vinylidene fluoride-co- chlorodifluoroethylene) (PVDF-CDFE), poly(vinylidene fluoride-co-trifluoroethylene-co- chlorofluoroethylene) (PVDF-TrFE-CFE), poly(vinylidene fluoride-co-trifluoroethylene-co- chlorotrifluoroethylene) (PVDF-TrFE-CTFE), poly(vinylidene fluoride-co-trifluoroethylene-co- hexafluoropropylene) (PVDF-TrFE-HFP), poly(vinylidene fluoride-co-trifluoroethylene-co- chlorodifluoroethylene) (PVDF-TrFE-CDFE), poly(vinylidene fluoride-co-tetrafluoroethylene- co-chlorofluoroethylene) (PVDF-TFE-CFE), poly(vinylidene fluoride-co-tetrafluoroethylene- co-chlorotrifluoroethylene) (PVDF-TFE-CTFE), poly(vinylidene fluoride-co- tetrafluoroethylene-co-hexafluoropropylene) (PVDF-TFE-HFP), and poly(vinylidene fluoride- co-tetrafluoroethylene-co- chlorodifluoroethylene) (PVDF-TFE-CD FE), or a polymeric blend thereof. Embodiment 21 is the method of embodiment 20, wherein the PVDF-based polymer is PVDF. Embodiment 22 is the method of any one of embodiments 1 to 21, wherein the organic ferroelectric polymer material does not contain a metal alkoxide. Embodiment 23 is the method of any one of embodiments 1 to 22, wherein depositing step (c) comprises a spin coating process, a wire-bar coating process, a doctor-blading process, or a roll to roll process. Embodiment 24 is the method of any one of embodiments 1 to 23, wherein steps (a) through (c) are performed in 60 minutes or more. Embodiment 25 is the method of any one of embodiments 1 to 24, wherein the temperature of the substrate is 80 °C or less, 50 °C or less, 30 °C or less, or at ambient temperature. Embodiment 26 is the method of any one of embodiments 1 to 25, wherein the substrate is not heated during step (b).

Embodiment 27 is a method for controlling the surface roughness of a ferroelectric film having ferroelectric hysteresis properties. The method can include (a) reducing the amount of water diffusing into a composition comprising a solvent and an organic ferroelectric polymer solubilized therein by heating the composition to a targeted temperature range that is above room temperature and below the boiling point of the solvent, wherein the targeted temperature range corresponds to a targeted surface morphology of the ferroelectric film; (b) depositing the heated composition onto a substrate; and (c) annealing the heated composition to form a ferroelectric film having ferroelectric hysteresis properties, a thickness of 400 nanometers or less, and the targeted surface morphology. Embodiment 28 is the method of embodiment 27, wherein the film has a surface roughness of 20 nanometers or less as determined by atomic force microscopy (AFM). Embodiment 29 is the method of any one of embodiments 27 or 28, wherein the targeted temperature is above 75 °C, preferably above 75 °C to 200 °C, more preferably above 75 °C to 150 °C, and most preferably from 80 °C to 120 °C. Embodiment 30 is the method of any one of embodiments 27 to 29, wherein the thickness of the ferroelectric film is 350 nm or less, 300 nm, or less, 10 nm to 400 nm, preferably 140 nm to 300 nm, and most preferably from 200 nm to 300 nm. Embodiment 31 is the method of any one of embodiments 27 to 30, wherein the ferroelectric polymer is PVDF or a blend thereof. Embodiment 32 is the method of any one of embodiments 27 to 31, wherein the composition is a solution, a gel, or a melt. Embodiment 33 is the method of embodiment 32, wherein the composition is a solution. Embodiment 34 is the method of any one of embodiments 27 to 33, wherein the composition comprises about 3 wt. % to about 12 wt. % of the organic ferroelectric polymer. Embodiment 35 is the method of any one of embodiments 27 to 34, wherein the targeted surface morphology of the ferroelectric film is sufficient for adhesion of the ferroelectric film to an electrode deposited onto the surface of the ferroelectric film. Embodiment 36 is the method of any one of embodiments 27 to 35, wherein the ferroelectric film has an absorbance between the wavelengths of 300 to 1000 nm of 10-1 a.u. or less. Embodiment 37 is the method of any one of embodiments 27 to 36, wherein depositing the heated composition onto a substrate is performed at a relative humidity of 50% or less. Embodiment 38 is the method of any one of embodiments 27 to 37, wherein the composition comprises about 5 to 10 wt. % of the organic ferroelectric polymer, the targeted temperature is about 75 to 125 °C and the targeted surface morphology is 5 to 20 nm, or preferably wherein the solution comprises about 8.2 wt. % of the organic ferroelectric polymer, the targeted temperature is about 100 °C and the targeted surface morphology is 10 nm. Embodiment 39 is the method of any one of embodiments 27 to 38, wherein the substrate comprises a lower electrode, and wherein the heated composition is deposited on the lower electrode. Embodiment 40 is the method of embodiment 39, further comprising depositing an upper electrode on the ferroelectric film. Embodiment 41 is the method of any one of embodiments 27 to 40, wherein the solvent comprises dimethylformamide, dimethyl acetate, dimethylacetamide, tetramethyl urea, dimethyl sulfoxide, trimethyl phosphate, N-methyl-2-pyrrolidone, diethyl carbonate, or any combination thereof. Embodiment 42 is the method of any one of embodiments 27 to 30 or 32 to 41, wherein the organic ferroelectric polymer is a polyvinylidene fluoride (PVDF)-based polymer, a polyundecanoamide (Nylon 11)-based polymer, or a blend thereof. Embodiment 43 is the method of embodiment 42, wherein the PVDF-based polymer is a homopolymer, a copolymer, or a terpolymer, or a blend thereof. Embodiment 44 is the method of any of one of embodiments 42 to 43, wherein the PVDF-based polymer is blended with a non-PVDF-based polymer. Embodiment 45 is the method of embodiment 44, wherein the non-PVDF polymer is a poly(phenylene oxide) (PPO), a polystyrene (PS), or a poly(methyl methacrylate) (PMMA), or a blend thereof. Embodiment 46 is the method of any of one of embodiments 42 to 45, wherein the PVDF-based polymer is PVDF, a poly(vinylidene fluoride-tetrafluoroethylene) (PVDF-TrFE), or a poly(vinylidene-fluoride-co-hexafluoropropene) (PVDF-HFP), poly(vinylidene fluoride-co-chlorotrifluoroethylene) (PVDF-CTFE), poly(vinylidene fluoride-co-chlorofluoroethylene) (PVDF-CFE), poly(vinylidene fluoride-co- chlorodifluoroethylene) (PVDF-CDFE), poly(vinylidene fluoride-co-trifluoroethylene-co- chlorofluoroethylene) (PVDF-TrFE-CFE), poly(vinylidene fluoride-co-trifluoroethylene-co- chlorotrifluoroethylene) (PVDF-TrFE-CTFE), poly(vinylidene fluoride-co-trifluoroethylene-co- hexafluoropropylene) (PVDF-TrFE-HFP), poly(vinylidene fluoride-co-trifluoroethylene-co- chlorodifluoroethylene) (PVDF-TrFE-CDFE), poly(vinylidene fluoride-co-tetrafluoroethylene- co-chlorofluoroethylene) (PVDF-TFE-CFE), poly(vinylidene fluoride-co-tetrafluoroethylene- co-chlorotrifluoroethylene) (PVDF-TFE-CTFE), poly(vinylidene fluoride-co- tetrafluoroethylene-co-hexafluoropropylene) (PVDF-TFE-HFP), and poly(vinylidene fluoride- co-tetrafluoroethylene-co- chlorodifluoroethylene) (PVDF-TFE-CD FE), or a polymeric blend thereof. Embodiment 47 is the method of embodiment 467, wherein the PVDF-based polymer is PVDF. Embodiment 48 is the method of any one of embodiments 27 to 47, wherein the organic ferroelectric polymer material does not contain a metal alkoxide. Embodiment 49 is the method of any one of embodiments 27 to 48, wherein depositing step (b) comprises a spin coating process, a wire-bar coating process, a doctor-blading process, or a roll to roll process. Embodiment 50 is the method of any one of embodiments 27 to 49, wherein the temperature of the substrate is 80 °C or less, 50 °C or less, 30 °C or less, or at ambient temperature. Embodiment 51 is the method of any one of embodiments 27 to 50, wherein the substrate is not heated during step (b).

Embodiment 52 is a ferroelectric capacitor, thin film transistor, or diode comprising the organic ferroelectric film having ferroelectric hysteresis properties produced from the methods of any one of embodiments 1 to 51, wherein the ferroelectric capacitor, thin film transistor, or diode includes a first conductive material and a second conductive material, wherein at least a portion of the organic ferroelectric film is disposed between at least a portion of the first conductive material and at least a portion of the second conductive material. Embodiment 53 is the ferroelectric capacitor, thin film transistor, or diode of embodiment 52, wherein the ferroelectric capacitor, thin film transistor, or diode is comprised on a substrate. Embodiment 54 is the ferroelectric capacitor, thin film transistor, or diode of embodiment 53, wherein the substrate comprises silicon, plastic, or paper.

Embodiment 55 is a printed circuit board comprising the ferroelectric film produced by the methods of any one of embodiments 1 to 51 or the ferroelectric capacitor, thin film transistor, or diode of any one of embodiments 52 to 54.

Embodiment 56 is an integrated circuit comprising the ferroelectric film produced by the methods of any one of embodiments 1 to 51 or the ferroelectric capacitor, thin film transistor, or diode or of any one of embodiments 52 to 54.

Embodiment 57 is an electronic device comprising the ferroelectric film produced by the method of any one of embodiments 1 to 51 or the ferroelectric capacitor, thin film transistor, or diode of any one of embodiments 52 to 54.

Embodiment 58 is a method of decoupling a circuit from a power supply with the ferroelectric capacitor, thin film transistor, or diode of any one of embodiments 52 to 54, the method comprising positioning the ferroelectric capacitor, thin film transistor, or diode between a power voltage line and a ground voltage line, wherein the ferroelectric capacitor or thin film transistor is coupled to the power voltage line and to the ground voltage line, and wherein a reduction in power noise generated by the power voltage and the ground voltage is achieved.

Embodiment 59 is a method for operating an energy storage circuit comprising the ferroelectric capacitor, thin film transistor, or diode of any one of embodiments 52 to 54 which provides electrical power to a consuming device when electrical power from a primary source is unavailable. The method can include: defining a target energy level for the ferroelectric capacitor, thin film transistor, or diode; charging the ferroelectric capacitor, thin film transistor, or diode; measuring a first amount of energy that is stored in the ferroelectric capacitor, thin film transistor, or diode during charging; terminating charging of the ferroelectric capacitor, thin film transistor, or diode when the first amount of energy stored in the capacitor, thin film transistor, or diode reaches the target energy level; and discharging the capacitor, thin film transistor, or diode into the consuming device when electrical power from the primary source becomes unavailable.

Embodiment 60 is a method for operating a piezoelectric sensor, a piezoelectric transducer, and a piezoelectric actuator using the ferroelectric capacitor, thin film transistor, or diode of any one of embodiments 52 to 54.

Embodiment 61 is a ferroelectric film having ferroelectric hysteresis properties, the film comprising an organic ferroelectric polymer, a thickness of 400 nm or less, and a smooth surface morphology. Embodiment 62 is the ferroelectric film of embodiment 61, wherein the film comprises a thickness of 350 nm or less, 300 nm, or less, 10 nm to 400 nm, preferably 140 nm to 300 nm, and most preferably from 200 nm to 300 nm. Embodiment 63 is the ferroelectric film of any one of embodiments 61 to 62, wherein the film has a surface roughness of 20 nm or less as determined by Atomic Force Microscopy (AFM). Embodiment 64 is the ferroelectric film of embodiment 61, wherein the film has a surface morphology as substantially depicted in FIG. 13C. Embodiment 65 is the ferroelectric film of embodiment 61, wherein the film has a surface morphology as substantially depicted in FIG. 13D. Embodiment 66 is the ferroelectric film of embodiment 61, wherein the film has a surface morphology as substantially depicted in FIG. 13E. Embodiment 67 is the ferroelectric film of any one of embodiments 61 to 66, wherein the film is transparent. Embodiment 68 is the ferroelectric film of embodiment 67, wherein the film has an absorbance between the wavelengths of 300 to 1000 nm of 10-1 a.u. or less. Embodiment 69 is the ferroelectric film of any one of embodiments 61 to 68, wherein the organic ferroelectric polymer is a polyvinylidene fluoride (PVDF)-based polymer, a polyundecanoamide (Nylon 11)-based polymer, or a blend thereof. Embodiment 70 is the ferroelectric film of embodiment 69, wherein the PVDF-based polymer is a homopolymer, a copolymer, or a terpolymer, or a blend thereof. Embodiment 71 is the ferroelectric film of any one of embodiments 69 to 70, wherein the PVDF-based polymer is blended with a non-PVDF-based polymer. Embodiment 72 is the ferroelectric film of embodiment 71, wherein the non-PVDF polymer is a poly(phenylene oxide) (PPO) polymer, a polystyrene (PS) polymer, or a poly(methyl methacrylate) (PMMA) polymer, or a blend thereof. Embodiment 73 is the ferroelectric film of any one of embodiments 69 to 72, wherein the PVDF-based polymer is PVDF, a poly(vinylidene fluoride-tetrafluoroethylene) (PVDF-TrFE), or a poly(vinylidene-fluoride-co-hexafluoropropene) (PVDF-HFP), poly(vinylidene fluoride-co-chlorotrifluoroethylene) (PVDF-CTFE), poly(vinylidene fluoride-co-chlorofluoroethylene) (PVDF-CFE), poly(vinylidene fluoride-co- chlorodifluoroethylene) (PVDF-CDFE), poly(vinylidene fluoride-co-trifluoroethylene-co- chlorofluoroethylene) (PVDF-TrFE-CFE), poly(vinylidene fluoride-co-trifluoroethylene-co- chlorotrifluoroethylene) (PVDF-TrFE-CTFE), poly(vinylidene fluoride-co-trifluoroethylene-co- hexafluoropropylene) (PVDF-TrFE-HFP), poly(vinylidene fluoride-co-trifluoroethylene-co- chlorodifluoroethylene) (PVDF-TrFE-CDFE), poly(vinylidene fluoride-co-tetrafluoroethylene- co-chlorofluoroethylene) (PVDF-TFE-CFE), poly(vinylidene fluoride-co-tetrafluoroethylene-co-chlorotrifluoroethylene) (PVDF-TFE-CTFE), poly(vinylidene fluoride-co-tetrafluoroethylene-co- hexafluoropropylene) (PVDF-TFE-HFP), and poly(vinylidene fluoride- co-tetrafluoroethylene-co- chlorodifluoroethylene) (PVDF-TFE-CD FE), or a polymeric blend thereof. Embodiment 74 is the ferroelectric film of embodiment 73, wherein the PVDF-based polymer is PVDF. Embodiment 75 is the ferroelectric film of embodiment 74, wherein the PVDF has a beta (β), gamma (γ), delta (δ), or epsilon (ε), preferably a gamma (γ) phase. Embodiment 76 is the ferroelectric film of any one of embodiments 61 to 75, wherein the film does not contain a metal alkoxide.

Embodiment 77 is an electronic device, printed circuit board, or integrated circuit comprising any one of the ferroelectric films of embodiments 61 to 76. Embodiment 78 is a ferroelectric capacitor, a thin film transistor, or a diode comprising any one of the ferroelectric films of embodiments 61 to 76.

Embodiment 79 is a device comprising any one of the ferroelectric films of embodiments 61 to 76, wherein the device is a smartcard, a RFID card or tag, a piezoelectric sensor, a piezoelectric transducer, a piezoelectric actuator, a pyroelectric sensor, a memory device, a non-volatile memory cell, a standalone memory cell, a firmware, a microcontroller, a gyroscope, an acoustics sensor, an actuator, a micro-generator, a power supply circuit, a circuit coupling and decoupling device, a radio frequency filtering device, a delay circuit, a radio frequency tuner, a passive infra-red sensor, an infrared imaging array, or a fingerprint sensor.

Ambient temperature means the temperature of the surrounding environment or room. For example, ambient room temperature is the temperature of a room, which typically ranges from 15 °C to 30 °C, and preferably 23 to 27 °C.

The term "electrode" or "contact" as used in the context of the present invention refers to a conductive material coupled to a component to provide an electrical contact point to the component. For example, in certain embodiments, a device may include two electrodes on opposite sides of an insulator material, such as a ferroelectric layer.

The terms "lower" or "bottom" electrode or "interconnect" as used in context of the present invention refers to a conducting material positioned on a side of a component closest to the supporting substrate.

The terms "upper" or "top" electrode as used in context of the present invention refers to an electrode positioned on a side of a component farthest from the supporting substrate. Although "bottom electrode" and "top electrode" are defined here and described throughout the disclosure, the terms may be interchangeable, such as when a device is separate from the supporting substrate.

The term "ferroelectric" includes all materials, both organic and inorganic, that exhibit properties, such as retaining a remnant electric field polarization at zero applied electric field.

The phrase "polymer blend" includes at least two polymers that have been blended together by any of the known techniques for producing polymer blends. Such techniques include solution blending using a common solvent or melt blend extrusion whereby the components are blended at temperatures above the melting point of the polymers and the obtained mixture is subsequently extruded into granules or directly into sheets or any other suitable form. Screw extruders or mills are commonly used for melt blending polymers. It will also be appreciated the blend of polymers may be a simple powder blend providing that the blend is subjected to a homogenizing process before or during the process of fabricating the ferroelectric polymer of the present invention. Thus, for example, where a ferroelectric polymer is formed from at least two polymers in a screw-fed injection-molding machine, the feed to the hopper of the screw may be a simple mixture of the two polymers since a blend may be achieved in the screw portion of the machine.

The term "polymer" includes oligomers (e.g., a polymer having 2 to 10 monomeric units or 2 to 5 monomeric units) and polymers (e.g., a polymer having greater than 10 monomeric units).

The term "about" or "approximately" are defined as being close to as understood by one of ordinary skill in the art, and in one non-limiting embodiment the terms are defined to be within 10%, preferably within 5%, more preferably within 1%, and most preferably within 0.5%.

The term "substantially" and its variations are defined as being largely but not necessarily wholly what is specified as understood by one of ordinary skill in the art, and in one non-limiting embodiment substantially refers to ranges within 10%, within 5%, within 1%, or within 0.5%.

The terms "inhibiting" or "reducing" or "preventing" or "avoiding" or any variation of these terms, when used in the claims and/or the specification includes any measurable decrease or complete inhibition to achieve a desired result.

The term "effective," as that term is used in the specification and/or claims, means adequate to accomplish a desired, expected, or intended result.

The use of the word "a" or "an" when used in conjunction with the term "comprising" in the claims or the specification may mean "one," but it is also consistent with the meaning of "one or more," "at least one," and "one or more than one."

The words "comprising" (and any form of comprising, such as "comprise" and "comprises"), "having" (and any form of having, such as "have" and "has"), "including" (and any form of including, such as "includes" and "include") or "containing" (and any form of containing, such as "contains" and "contain") are inclusive or open-ended and do not exclude additional, unrecited elements or method steps.

The method of the present invention can "comprise," "consist essentially of," or "consist of" particular ingredients, components, compositions, *etc.* disclosed throughout the specification. With respect to the transitional phase "consisting essentially of," in one non-limiting aspect, a basic and novel characteristic of the present invention is the production of ferroelectric films having ferroelectric hysteresis properties and acceptable surface morphologies that can be produced in ambient conditions without the need for controlling the humidity and temperature of the environment. Further, the processes of the present invention do not require the use of non-ferroelectric polymers to be blended with the composition (e.g., poly-(methyl methacrylate) (PMMA)), electrical poling, controlling of the cooling and heating rates during annealing, and/or the use of additives.

Other objects, features and advantages of the present invention will become apparent from the following figures, detailed description, and examples. It should be understood, however, that the figures, detailed description, and examples, while indicating specific embodiments of the invention, are given by way of illustration only and are not meant to be limiting. It is also contemplated that features from some aspects may be combined with features from other aspects. Additionally, it is contemplated that changes and modifications within the spirit and scope of the invention will become apparent to those skilled in the art from this detailed description.

### BRIEF DESCRIPTION OF THE DRAWINGS

**FIG. 1** is a schematic of producing a thin organic ferroelectric film of the present invention.
**FIG. 2** is a 2-D cross-sectional view of a ferroelectric device that can be controlled through the processes and apparatuses of the present invention.
**FIGS. 3A to 3D** are schematics of four configurations of various ferroelectric thin film transistors that can be controlled through the processes and apparatuses of the present invention.
**FIG. 4** is a schematic of implementation of a circuit in a semiconductor wafer or an electronic device using ferroelectric devices of the present invention.
**FIG. 5** is a schematic of implementation of an exemplary wireless communication system in which ferroelectric devices of the present invention may be advantageously employed.
**FIG. 6** is a schematic of an electronic circuit that includes the ferroelectric device of the present invention.
**FIG. 7** is a flowchart of a method for operating an energy storage circuit that includes ferroelectric device of the present invention.
**FIG. 8** is a schematic of a piezoelectric sensor circuit using the ferroelectric device of the present invention.
**FIG. 9** is a 2-D cross-sectional representation of the ferroelectric device with a piezoelectric layer of the present invention.
**FIG. 10** is a 2-D cross-sectional representation of the ferroelectric device with a pyroelectric material of the present invention.
**FIG. 11** depicts optical images of materials having the King Abdullah University Science and Technology (KAUST) logo in English and Arabic as viewed through ferroelectric films of the present invention and comparative ferroelectric films.
**FIG. 12A** depicts graphs of absorbance (a.u.) versus wavelength (nm) on a double logarithmic scale of ferroelectric films of the present invention.
**FIG. 12B** depicts graphs of absorbance (a.u.) versus wavelength (nm) on a double logarithmic scale of ferroelectric films of comparative ferroelectric films.
**FIG. 13** **(A-E)** depicts scanning electron microscopy images of ferroelectric films of the present invention (C-E) and comparative ferroelectric films (A-B).
**FIG. 14A** depict graphs of absorbance versus wavenumber (cm⁻¹) of ferroelectric films the present invention.
**FIG. 14B** depict graphs of absorbance versus wavenumber (cm⁻¹) of comparative ferroelectric films.
**FIG. 15** are graphs of polarization (uC/cm2) versus Electric Field (MV/m) for a ferroelectric device of the present invention.

### DETAILED DESCRIPTION OF THE INVENTION

It would be desirable to produce ferroelectric films having ferroelectric hysteresis properties under ambient conditions (i.e., temperature, atmospheric pressure, and humidity of the environment are not set/controlled). Previous attempts to process such films under ambient conditions have resulted in sub-par surface morphologies, sub-par optical qualities, and sub-par thicknesses for use in micro-electronic devices. This has led to the use of non-ambient conditions and/or the use of polymer blends (e.g., poly-(methyl methacrylate) (PMMA)), electrical poling, controlling of the cooling and heating rates during annealing, and/or the use of additives.

The discoveries of the present invention, by comparison, allow for the processing of nanoscale ferroelectric films under ambient conditions by controlling both the temperature of the composition to be processed into the film and the resulting thickness of the film. In particular, it was discovered that heating a composition that includes a solvent having an organic ferroelectric polymer solubilized therein to 75 °C or greater during deposition onto a substrate, followed by annealing (the temperature of the composition can be maintained prior to annealing), resulted in organic ferroelectric films having desirable optical properties and surface morphologies. Further, by maintaining the thickness of the resulting film to 400 nm or less, the optical properties can be further improved by increasing the film's transparency.

These and other non-limiting aspects of the present invention are discussed in further detail in the following sections.

### A. Compositions

Compositions that are used to make the ferroelectric films of the present invention include an organic ferroelectric polymer or a combination of such polymers and a solvent or combination of solvents that solubilized the polymer(s). Additionally, and if so desired, additives and non-ferroelectric polymers can be included in the composition. The amount of polymer used is an amount sufficient to produce a film having hysteresis properties and that remains in solution prior to annealing the composition. By way of example only, the amount can include up to 50 wt. % of the ferroelectric polymer, preferably up to 25 wt. %, more preferably up to 13 wt. %, and most preferably 3 wt. % to 12 wt.%. Additionally, the compositions can be formulated as solutions, gels, or melts. Solutions are preferred, as they can be easily used with solution-based processing techniques (e.g., preferred (e.g., spin coating process, a wire-bar coating process, a doctor-blading process, or a roll to roll process), with spin coating being particularly preferred.

Non-limiting examples of ferroelectric polymers include PVDF-based polymers, polyundecanoamide (Nylon 11)-based polymers, or blends of PVDF-based polymers or polyundecanoamide (Nylon 11)-based polymers. The PVDF-based polymer can be a homopolymer, a copolymer, or a terpolymer, or a blend thereof. A non-limiting example of a PVDF-based homopolymer polymer is PVDF. Non-limiting examples of PVDF-based copolymers are poly(vinylidene fluoride-tetrafluoroethylene) (PVDF-TrFE), poly(vinylidene- fluoride-co-hexafluoropropene) (PVDF-HFP), poly(vinylidene-fluoride-chlorotrifluoroethylene) (PVDF-CTFE) or poly(vinylidene-fluoride-chlorofluoroethylene) (PVDF-CFE). Non-limiting examples of PVDF-based terpolymers include poly(vinylidene-fluoride-trifluoroethylene-chlorotrifluoroethylene) (PVDF-TrFE-CTFE) or poly(vinylidene-fluoride-trifluoroethylene-chlorofluoroethylene) (PVDF-TrFE-CFE). The ferroelectric polymer can be blended with a non-ferroelectric polymer. Examples of non-ferroelectric polymers include a poly(phenylene oxide) (PPO), a polystyrene (PS), or a poly(methyl methacrylate) (PMMA), or blends thereof. A preferred polymer is PVDF or PVDF-TrFE, or a combination thereof.

Non-limiting examples of solvents and their respective boiling points (°C) that can be used to solubilize the ferroelectric polymers are provided below in Table 1. Solvents can be obtained from any suitable source such as, for example, SIGMA-ALDRICH®. Combinations of these solvents can also be used. A non-limiting example of a glycol ether that has a boiling point of 118 °C is propylene glycol monomethyl ether.

**Table 1**

| **Solvent** | **Boiling Point (°C)** |
|---|---|
| Acetone | 56 |
| Tetrahydrofuran | 65 |
| Methyl ethyl ketone | 80 |
| Dimethyl formamide | 153 |
| Dimethyl acetamide | 166 |
| Tetramethyl urea | 177 |
| Dimethyl sulfoxide | 189 |
| Trimethyl phosphate | 195 |
| N-Methyl-2-pyrrolidone | 202 |
| Methyl isobutyl ketone | 118 |
| Glycol ethers | 118 |
| Glycol ether esters | 120 |
| N-Butyl acetate | 135 |
| Propylene glycol monomethyl ether acetate | 145 |
| Cyclohexanone | 157 |
| Diacetone alcohol | 167 |
| Diethyl carbonate | 167 |
| Di-isobutyl ketone | 169 |
| Ethyl acetoacetate | 180 |
| gamma-Butyrolactone | 204 |
| Isophorone | 215 |
| Triethyl phosphate | 215 |
| Carbitol acetate | 217 |
| Propylene carbonate | 242 |
| Glycerol triacetate | 259 |
| Dimethyl phthalate | 283 |
| Diglyme | 162 |
| Triethylene glycol | 285 |
| Triethylene glycol monobutyl ether | 265 |
| Triethylene glycol monomethyl ether | 122 |
| Tri(ethylene glycol) monoethyl ether | 256 |

The composition can be prepared by adding the ferroelectric polymer to the solvent under ambient conditions with continuous mixing until a homogeneous solution is obtained. The composition can be heated to at least 75 °C and up to the solvent's boiling point with a furnace, oven, hot, plate or any other heating source known to those of ordinary skill in the art. Notably, and instances where a solvent is used that has a boiling point less than 75° C (e.g., tetrahydrofuran or acetone), it is preferable to use such solvents in combination with solvents having boiling points of 75° C or greater.

### B. Production of Ferroelectric Films

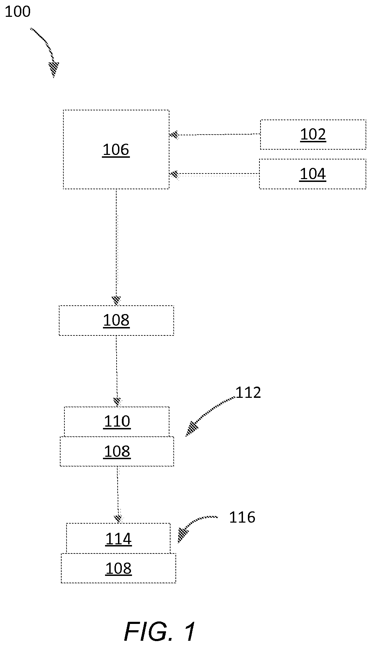

Referring to FIG. 1, a schematic of preparing a thin ferroelectric film is depicted. The organic ferroelectric polymeric material 102 (for example, the polymers described throughout the Specification) can be solubilized in the solvent 104 to form solution 106. Solublization of the ferroelectric polymeric material can be done at room temperature (e.g., 20 to 25 °C) to below 75 °C. Temperatures below 20 °C and above 75 °C can also be used for this solubilization step. The temperature of the solution can be raised to above 75 °C, but below the boiling point of the solvent. For example, the solution can be heated to above 75 °C to 258 °C or 75 °C to 200 °C, preferably above 75 °C to 150 °C, and most preferably from 80 °C to 120 °C. As previously discussed heating the solution 106 can inhibit ingress of water from the environment into the solution. The solution 106 can be deposited on a substrate 108 via spin-coating, spray coating, ultrasonic spray coating, roll-to-roll coating, ink-jet printing, screen printing, drop casting, dip coating, Mayer rod coating, gravure coating, slot die coating, doctor blade coating, extrusion coating, flexography, gravure, offset, rotary screen, flat screen, ink-jet, laser ablation, or any combination thereof. Preferably, spin coating is used. In some aspects of the invention, the atmosphere during deposition (for example, spin coating) is maintained at a humidity level of 0% to up to 50%, from 25% to 45%, or from 30% to 40%. The substrate 108 can be any material suitable for supporting a ferroelectric film or production of a ferroelectric device, and is discussed in detail in the following paragraphs. Controlling the humidity during deposition in combination with heating the solution to a targeted temperature inhibits the ingress of water during formation of the thin organic ferroelectric film. However, the process of the present invention can be practiced under ambient conditions without controlling the humidity, temperature, or pressure of the room or environment where the film is being made. The concentration of the solution 106 and deposition conditions onto the substrate 108 can be selected to form a polymeric film on the substrate that is less than 400 nm thick, preferably 140 to 300 nm thick. The substrate 108 can be heated to and/or maintained at a temperature of 80 °C, 70 °C, 50 °C, 20 °C or less. In some aspects of the invention substrate 108 can be heated to a desired temperature and then the heating is discontinued during the deposition. For example, the substrate can be heated to about the same temperature as solution temperature and then the heating is discontinued. In a preferred aspect of the invention, the substrate 108 is not heated, but used at ambient temperatures. Notably, thicker films can be processed in accordance with the presence invention (e.g., greater than 400 nm, greater than 450 nm, greater than 500 nm, greater than 550 nm, greater than 600 nm, greater than 700 nm, greater than 800 nm, greater than 900 nm, greater than 1000 nm). For example, the heated solution 106 having a desired concentration can be applied on the center of the substrate 108, which is spinning at a low speed or not at all. The substrate 108 can then be rotated at a high speed to spread the solution 106 by centrifugal force and evaporate the solvent 104 from the substrate. Rotation of substrate 108 can be continued until the solution 106 spins off the edges of the substrate 108 to form the organic ferroelectric polymer film 110 having a thickness of less than 500 nm. Deposition of the polymer onto the substrate forms stack 112, which includes substrate 108 and polymeric film 110. The thickness of the film 110 can be controlled by adjusting the concentration of the polymer in the solvent. For example, the solution 106 having about 5 to 10 wt. % or preferably about 8.2 wt.% of the polymer 106 can be used to make a 100 nm film. The solution 106 having about 4.5 to 5.0 wt.% or preferably about 4.9 wt.% of the polymer 106 can be used to make a 140 nm film. The solution 106 having about 5.5 to 6.5 wt.%, or preferably about 6.1 wt.% of the polymer 106 can be used to make a 200 nm film. The solution 106 having about 7.0 to 8.0 wt.% or preferably about 8.1 wt.% of the polymer 106 can be used to make a 300 nm film. The temperature of the solution 106 during deposition is maintained between 80 °C and 120 °C, between 90 °C and 110 °C, or between 110 °C and 120 °C. In a preferred aspect of the invention, the temperature of the solution is maintained from 105 °C to 120 °C. Stack 112 can be heated (annealed) at temperatures of about 100 °C to 160 °C, or from 110 °C to 150 °C, or from 120 to 140 °C to transform the organic ferroelectric film 110 to the ferroelectric film 114 having ferroelectric hysteresis properties (for example, transformation of a PVDF-type polymer from an alpha-polymorph to a beta-polymorph). The heat source for the annealing step can be standard ovens or hot plates. The time-frame for the annealing step can be an amount of time sufficient to produce a film having ferroelectric hysteresis properties (e.g., 5 to 60 minutes or more). The total time after heating the solution through annealing can be about 60 minutes or more.

As explained above, the processes of the present invention can also be used to obtain a targeted surface morphology or surface roughness as well as obtaining targeted optical properties. By way of example, the temperature of the solvent/ferroelectric polymer composition 106 can be selected to allow production of a thin organic ferroelectric film having ferroelectric properties with a targeted roughness. The ability to produce a film having varying surface morphologies allows the film to be used on a variety of substrates. For example, a film with a rough surface and acceptable optical properties can be used on a substrate having a smooth surface such as a glass substrate or polymeric substrate. The roughness of the film assists in frictional coupling of the film to the surface of the smooth glass substrate. In one aspect of the invention, the temperature of the solution, after solubilization of the organic ferroelectric polymer and prior to deposition onto a substrate, is selected to allow a desired amount of water to ingress into the solution. In certain aspects of the invention, the solution 106 can be heated to a temperature of about 100 °C and deposited on a substrate 108 using methods described throughout the Specification to produce the thin organic ferroelectric film 114 having a smooth surface roughness (for example, a surface roughness of about 10 nm as measured by atomic force microscopy (AFM)) with desired optical properties (for example, the ferroelectric film can have an absorbance between the wavelengths of 300 to 1000 nm of 10⁻¹ a.u. or less when plotted in double-logarithmic scale). If a thin ferroelectric film having a surface roughness of greater than 10 nm is desired, the solution 106 can be heated to about 80 to 90 °C and deposited on a substrate 108 using methods described throughout the Specification to produce the organic ferroelectric film 114 having thickness of less than 500 nm, more preferably between 140 and 300 nm, and a surface roughness of about 20 nm, as determined by AFM, with desired optical properties.

### C. Ferroelectric Devices

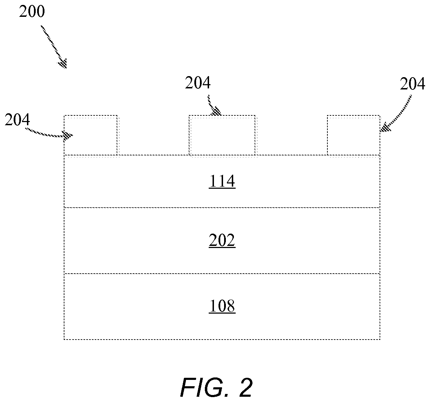

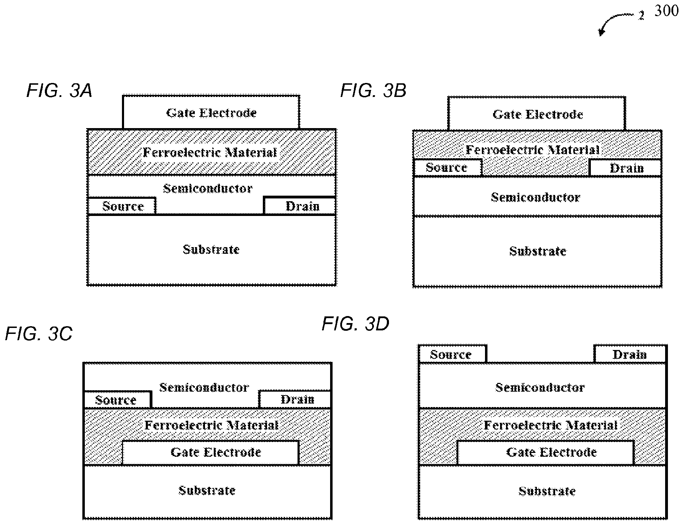

The stack 116 containing the thin organic ferroelectric film 114 having ferroelectric hysteresis properties can be used to produce ferroelectric devices. The ferroelectric devices can be a ferroelectric capacitor, ferroelectric transistor, or a ferroelectric diode. In some aspects of the invention, the ferroelectric device is used in pyroelectric applications and piezoelectric applications. FIGS. 2 and 3 each provide a view of ferroelectric components of ferroelectric devices. These devices can be integrated into a memory device and operated by a memory controller or other device according to the methods of the present invention. Referring to FIG. 2, a 2-D cross-sectional view of a ferroelectric device 200 of the present invention is depicted. The device 200 can include the substrate 108, the thin organic ferroelectric film 114, and a lower electrode or interconnect 202 that was previously deposited on the 108 prior to the ferroelectric film 114 (e.g., the substrate 108 included an interconnect layer 202). An upper electrode or contact 204 can be deposited on the ferroelectric film 114 to produce the ferroelectric device 200. Although shown as sharing the ferroelectric film 114 and the lower electrode 202, the ferroelectric film 114 and the lower electrode 202 may be patterned to form wholly separate structures. The ferroelectric device 200 can be fabricated on the substrate 108 by forming the ferroelectric film between the conducting electrodes 202 and 204. Additional materials, layers, and coatings (not shown) known to those of ordinary skill in the art can be used with the ferroelectric device 200, some of which are described below. An array of ferroelectric components may be manufactured by patterning, for example, the upper electrode 204. Other ferroelectric components that may be used to form memory arrays may be ferroelectric transistors (FeFETs), such as shown in FIGS. 3A-3D. FIGS. 3A through 3D represent various field effect transistors with varying configurations depicted of thin film transistors 300 that can be integrated into a memory device.

The ferroelectric devices of the present invention, for example, those depicted in FIGS. 2 and 3 are said to have "memory" because, at zero applied volts, it has two remnant polarization states that do not decay back to zero. These polarization states can be used to represent a stored value, such as binary 0 or 1, and are read by applying a sense voltage between the electrodes 202 and 204 and measuring a current that flows between the electrodes 202 and 204. The amount of charge needed to flip the polarization state to the opposite state can be measured and the previous polarization state is revealed. This means that the read operation changes the polarization state, and can be followed by a corresponding write operation, in order to write back the stored value by again altering the polarization state.

The substrate 108 can be used as a support. The substrate 108 can be made from material that is not easily altered or degraded by heat or organic solvents. Non-limiting examples of such materials include inorganic materials such as silicon, plastic, paper, banknotes substrates, which include polyethylene terephthalate, polycarbonates, polyetherimide, poly(methyl methacrylate), polyetherimides, or polymeric blends comprising such polymers. The substrate can be flexible or inflexible. The ferroelectric devices described herein may be produced on all types of substrates, including those that have low glass transition temperatures (T_{g}) (e.g., polyethylene terephthalate (PET), polyethylene (PE), polyvinyl chloride (PVC), polystyrene (PS), or polypropylene (PP)).

The lower electrode or interconnect 202 can be made of a conductive material. Typically, the lower electrode 202 can be obtained by forming a film using such a material (for example, vacuum deposition, sputtering, ion-plating, plating, coating, etc.). Non-limiting examples of conductive material that can be used to form a film include gold, platinum, silver, aluminum and copper, iridium, iridium oxide, and the like. In addition, non-limiting examples of conductive polymer materials include conducting polymers (such as PEDOT: PSS, polyaniline, graphene etc.), and polymers made conductive by inclusion of conductive micro- or nano-structures (such as silver nanowires). The thickness of the film for the lower electrode 202 is typically between 20 nm to 500 nm, although other sizes and ranges are contemplated for use in the context of the present invention. In some aspects of the invention, the substrate 108 and the lower electrode 202 are obtained as one unit from a commercial source.

The upper electrode or contact 204 can be disposed on the thin ferroelectric film 114 by, for example, thermal evaporation through a shadow mask to form stack 308. The film thickness of the upper electrode 204 is typically from 20 nm to 500 nm, or 50 nm to 100 nm. In some embodiments, the upper electrode 204 is deposited on precursor material 302 using spray coating, ultrasonic spray coating, roll-to-roll coating, ink-jet printing, screen printing, drop casting, spin coating, dip coating, Mayer rod coating, gravure coating, slot die coating, doctor blade coating, extrusion coating, or any combination thereof. The material used for the upper electrode 204 can be conductive. Non-limiting examples of such materials include metals, metal oxides, and conductive polymers (e.g., polyaniline, polythiophene, etc.) and polymers made conductive by inclusion of conductive micro- or nano-structures. In addition, non-limiting examples of conductive polymer materials include conducting polymers (such as PEDOT: PSS, polyaniline, graphene etc.), and polymers made conductive by inclusion of conductive micro- or nano-structures (such as gold nanowires). The upper electrode 204 can be a single layer or laminated layers formed of materials each having a different work function. Further, it may be an alloy of one or more of the materials having a low work function and at least one selected from the group consisting of gold, silver, platinum, copper, manganese, titanium, cobalt, nickel, tungsten, and tin. Examples of the alloy include a lithium-aluminum alloy, a lithium-magnesium alloy, a lithium-indium alloy, a magnesium-silver alloy, a magnesium-indium alloy, a magnesium-aluminum alloy, an indium-silver alloy, and a calcium-aluminum alloy. The film thickness of the upper electrode 204 is typically from 20 nm to 500 nm, or 50 nm to 100 nm. In some embodiments, the top electrode 108 is deposited on ferroelectric film 114 spray coating, ultrasonic spray coating, roll-to-roll coating, ink-jet printing, screen printing, drop casting, spin coating, dip coating, Mayer rod coating, gravure coating, slot die coating, doctor blade coating, extrusion coating, or any combination thereof.

### D. Applications for Ferroelectric Devices

Any one of the ferroelectric devices of the present invention can be used in a wide array of technologies and devices including but not limited to: smartcards, RFID cards/tags, piezoelectric sensors, piezoelectric transducers, piezoelectric actuators, pyroelectric sensors, memory devices, non-volatile memory, standalone memory, firmware, microcontrollers, gyroscopes, acoustics sensors, actuators, micro-generators, power supply circuits, circuit coupling and decoupling, radio frequency filtering, delay circuits, radio frequency tuners, passive infra-red sensors ("people detectors"), infrared imaging arrays and fingerprint sensors. If implemented in memory, including firmware, functions may be stored in the ferroelectric device as one or more instructions or code on a computer-readable medium. Examples include computer-readable media encoded with a data structure and computer-readable media encoded with a computer program. Computer-readable media includes physical computer storage media. Combinations of the above should also be included within the scope of computer-readable media.

In many of these applications thin films are typically used, as this allows the field required to switch the polarization to be achieved with a moderate voltage. Although some specific circuitry has been set forth, it will be appreciated by those skilled in the art that not all of the disclosed circuitry is required to practice the disclosure. Moreover, certain well known circuits have not been described, to maintain focus on the disclosure.

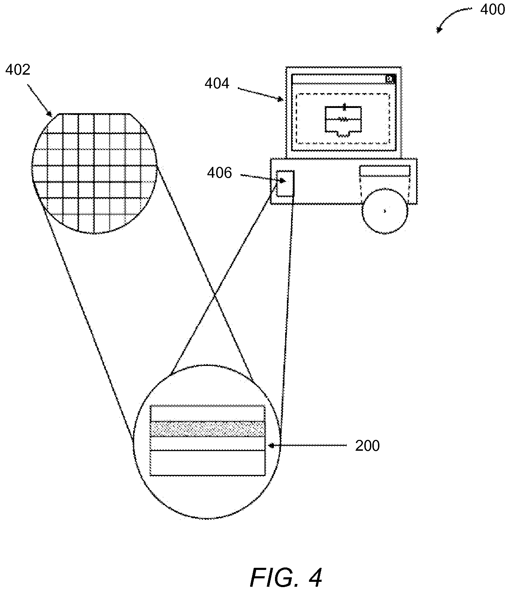

FIG. 4 is schematic depicting implementation of an integrated circuit in a semiconductor wafer or an electronic device according to one embodiment. In one case, a ferroelectric device 200 (for example, as a capacitor, transistor, or a diode) may be found in a wafer 402. The wafer 402 may be singulated into one or more dies that may contain the ferroelectric device 200. Additionally, the wafer 402 may experience further semiconductor manufacturing before singulation. For example, the wafer 402 may be bonded to a carrier wafer, a packaging bulk region, a second wafer, or transferred to another fabrication facility. Alternatively, an electronic device 404 such as, for example, a personal computer, may include a memory device 406 that includes the ferroelectric device 200. Additionally, other parts of the electronic device 404 may include the ferroelectric device 200 such as a central processing unit (CPU), a digital-to-analog converter (DAC), an analog-to-digital converter (ADC), a graphics processing unit (GPU), a microcontroller, or a communications controller.

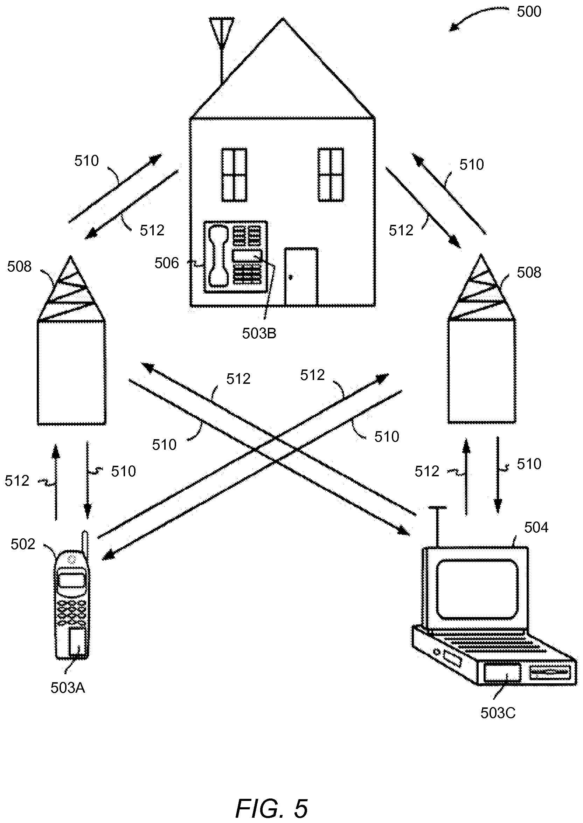

FIG. 5 is a block diagram showing an exemplary wireless communication system 500 in which an embodiment of the disclosure may be advantageously employed. For purposes of illustration, FIG. 5 shows three remote units 502, 504, and 506 and two base stations 508. It will be recognized that wireless communication systems may have many more remote units and base stations. Remote units 502, 504, and 506 include circuit devices 503A, 503C and 503B, which may include integrated circuits or printable circuit boards that include the disclosed ferroelectric device, for example, a ferroelectric device made by the processes of the present invention. It will be recognized that any device containing an integrated circuit or printable circuit board may also include the ferroelectric devices disclosed herein, including the base stations, switching devices, and network equipment. FIG. 5 shows forward link signals 510 from the base station 508 to the remote units 502, 504, and 506 and reverse link signals 512 from the remote units 502, 504, and 506 to base stations 508.

The remote unit 502 is shown as a mobile telephone, the remote unit 506 is shown as a portable computer, and the remote unit 504 is shown as a fixed location remote unit in a wireless local loop system. For example, the remote units may be mobile phones, hand-held personal communication systems (PCS) units, portable data units such as personal data assistants, GPS enabled devices, navigation devices, set upper boxes, music players, video players, entertainment units, fixed location data units such as meter reading equipment, tablets, or any other device that stores or retrieves data or computer instructions, or any combination thereof. Although FIG. 5 illustrates remote units according to the teachings of the disclosure, the disclosure is not limited to these exemplary illustrated units. Embodiments of the disclosure may be suitably employed in any device which includes the ferroelectric device 100 made by the processes disclosed by the present invention.

Ferroelectric components, such as the ferroelectric devices described throughout this application, may be operated as memory cells to store data, such as information, code, or instructions. For example, a single ferroelectric capacitor may store a single bit of information, e.g., '1' or '0.' This '1' or '0' value may be stored as a binary polarization direction of the ferroelectric layer in the ferroelectric component. For example, when the ferroelectric layer is polarized from top to bottom, the ferroelectric component stores a '1', and when the ferroelectric layer is polarized from bottom to top, the ferroelectric component stores a '0.' This mapping of polarization states is only one example. Different polarization levels may be used to represent the '1' and '0' data bits in different embodiments of the present invention.

### E. Operation of a Controller for a Ferroelectric Memory Device for Storing Multiple Bits of Information in Memory Cells of the Ferroelectric Memory Device

A ferroelectric memory device may be constructed with an array of ferroelectric memory devices described above, in which each device comprises a ferroelectric memory cell. Read and write operations to the ferroelectric memory device may be controlled by a memory controller coupled to the array of multi-level ferroelectric memory cells. One example of a write operation performed by the controller to store information in a single ferroelectric memory cell is described below. A method may include receiving a bit and an address for writing to the addressed ferroelectric memory cell. The bit may be, for example '0' or '1.' Then, a write pulse of a predetermined voltage may be applied across the top and bottom electrodes of the memory cell. The write pulse may create a certain level of remnant polarization in the ferroelectric layer of the ferroelectric memory cell. That remnant polarization affects characteristics of the ferroelectric memory cell, which may be measured at a later time to retrieve the bit that was stored in the ferroelectric memory cell. The cell programming may also include other variations in the write pulse. For example, the controller may generate multiple write pulses to apply to the memory cell to obtain the desired remnant polarization in the ferroelectric layer. In some embodiments, the controller may be configured to follow a write operation with a verify operation. The verify operation may be performed with select write operations, all write operations, or no write operations. The controller may also execute a read operation to obtain the bit stored in the ferroelectric memory cell.

In an array of ferroelectric memory cells, the array may be interconnected by word lines extending across rows of memory cells and bit lines extending across columns of memory cells. The memory controller may operate the word lines and bit lines to select particular memory cells from the array for performing read and/or write operations according to address received from a processor or other component requesting data from the memory array. Appropriate signals may then be applied to the word lines and bit lines to perform the desired read and/or write operation.

### F. Operation as a Decoupling Capacitor and as an Energy Storage Device

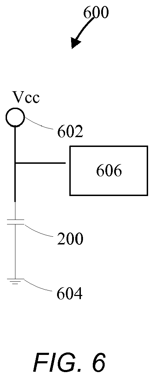

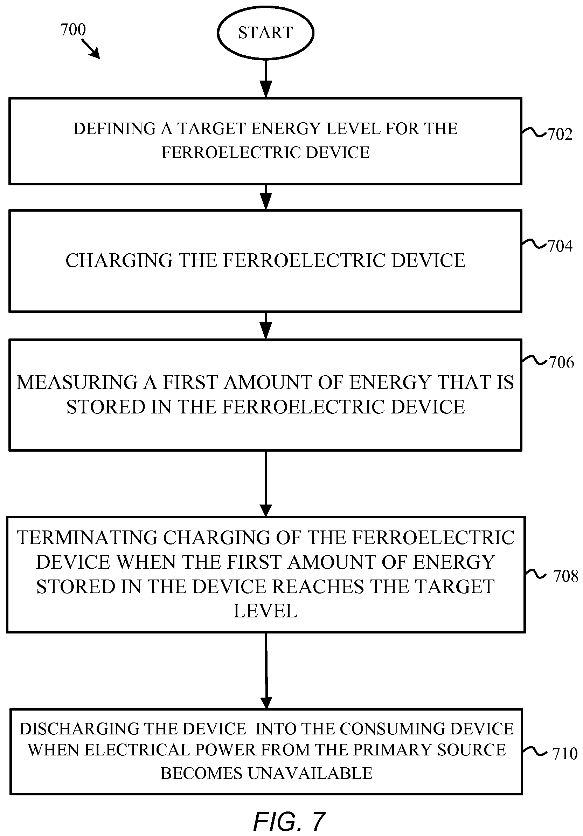

The ferroelectric device, for example, a ferroelectric capacitor, of the present invention can be used to decouple one part of an electrical network (circuit) from another. FIG. 6 is a schematic of circuit 600 that includes the ferroelectric device 200 as a ferroelectric capacitor. Ferroelectric capacitor 200 is coupled to power voltage line 602 and a ground voltage line 604. Power noise generated by the power voltage and the ground voltage is shunted through the capacitor, and thus reducing the overall power noise in the circuit 606. The ferroelectric capacitor 200 can provide local energy storage for the device by providing releasing charge to the circuit when the voltage in the line drops. FIG. 7 is a flowchart of a method for operating an energy storage circuit that includes ferroelectric device 200. The ferroelectric device 200 can provide electrical power to a consuming device when electrical power from a primary source is unavailable. Method 700 of FIG. 7 begins at block 702 with defining a target energy level for the ferroelectric device. The target energy level may be, for example, 0.1 µF to 20 µF, for a ferroelectric capacitor of the present invention. After the target energy level is defined, at block 704 the ferroelectric device 200 is charged to the defined energy level. At block 706, a first amount of energy that is stored in the ferroelectric device 200 is measured. When the first amount of energy stored in the ferroelectric device 200 reaches the target energy level, the charging is terminated at block 708. At block 710, when electrical power becomes unavailable from the primary source (for example, a voltage source), the ferroelectric device 200 will discharge energy into the consuming device (for example, a smart phone, computer, or tablet).

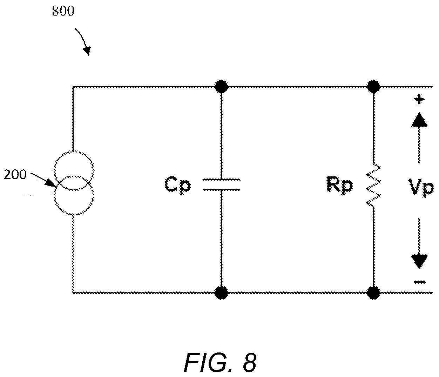

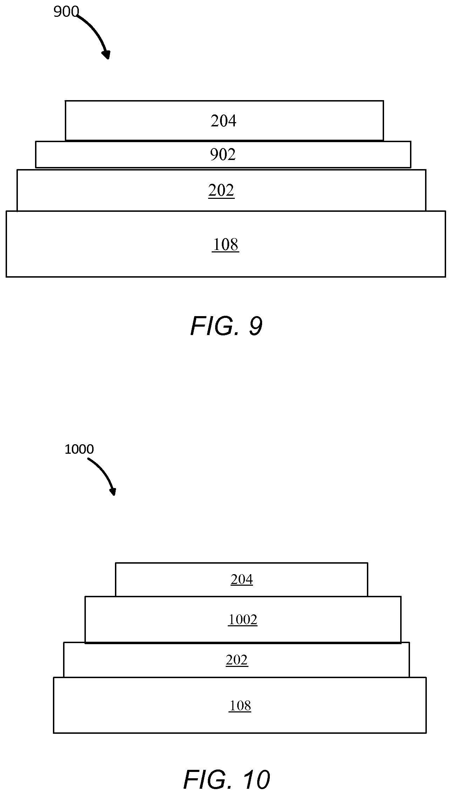

FIG. 8 is a schematic of a piezoelectric sensor circuit using the ferroelectric device 200 as a piezoelectric device in a circuit. When a piezoelectric sensor is at rest, the dipoles formed by the positive and negative ions cancel each other due to the symmetry of the polymer structure, and an electric field is not observed. When stressed, the polymer deforms, symmetry is lost, and a net dipole moment is created. The dipole moment creates an electric field across the polymer. The materials generate an electrical charge that is proportional to the pressure applied. As shown in FIG. 8, the piezoelectric sensor 800 includes a ferroelectric device 200 as the piezoelectric component of the sensor. It is also envisioned that the ferroelectric device 200 of the present invention can be used as the decoupling device (for example, a capacitor) in the same circuit. FIG. 9 is a 2-D cross-sectional representation of the ferroelectric device 200 in combination with the thin organic ferroelectric film 114 being used being used as a piezoelectric material 902. As shown in FIG. 9, piezoelectric material 902 with made using the process described throughout this specification can be disposed between lower electrode 204 and upper electrode 202 in a piezoelectric device, and, when stressed create a net dipole moment. A method of using a ferroelectric device of the present invention as a piezoelectric device includes sending a vibrational pulse to the piezoelectric device; comparing the device voltage to a reference voltage and adjusting the vibration pulses in response to the comparison. FIG. 10 is a 2-D cross-sectional representation of the ferroelectric device 200 in combination with the thin organic ferroelectric film 114 being used as a pyroelectric material 1002. As shown in FIG. 10, pyroelectric material 1002 as made using the process described throughout this specification and having ferroelectric hysteresis properties can be disposed between lower electrode 202 and upper electrode 204 in a pyroelectric device, and will generate a charge when exposed to infrared light. A method of using a ferroelectric device of the present invention as a pyroelectric device includes sending heat pulse to the pyroelectric device; comparing the device voltage to a reference voltage and adjusting the heat pulses in response to the comparison.

### EXAMPLES

The present invention will be described in greater detail by way of specific examples. The following examples are offered for illustrative purposes only, and are not intended to limit the invention in any manner. Those of skill in the art will readily recognize a variety of noncritical parameters which can be changed or modified to yield essentially the same results.

### Example 1

### (Preparation of Ferroelectric Thin Films)

A ferroelectric film of the present invention was fabricated using the following method.
**Sample 1. Deposition of PVDF on Glass Substrate Using an 80 °C Solution.** A PVDF polymer (0.082 g) was added to dimethyl formamide (DMF) (1 mL) and heated to 80 °C to solubilize the PVDF polymer in the solvent. The PVDF/solvent solution was maintained 80 °C and spun-casted on a glass substrate at 4000 rpm at a relative humidity of 50% to form a film on the glass substrate. The PVDF film had a thickness of 250 nm.
**Sample 2. Deposition of PVDF on Glass Substrate Using a 100 °C Solution.** A PVDF polymer (0.082 g) was added to DMF (1 mL) and heated to 100 °C to solubilize the PVDF polymer in the solvent. The PVDF/solvent solution was maintained at 100 °C and spun-casted on a glass substrate at 4000 rpm at a relative humidity of 50% to form a film on the glass substrate. The PVDF film had a thickness of 320 nm.
**Sample 3. Deposition of PVDF on Glass Substrate Using a 120 °C Solution.** A PVDF polymer (0.082 g) was added to DMF (1 mL) and heated to 120 °C to solubilize the PVDF polymer in the solvent. The PVDF/solvent solution was maintained at 120 °C and spun-casted on a glass substrate at 4000 rpm at a relative humidity of 50% to form a film on the glass substrate. The PVDF film had a thickness of 340 nm.

### Example 2 (Preparation of Comparative Thin Film Samples)

**Comparative Sample C1. Deposition of PVDF on Glass Substrate Using a Room Temperature Solution.** A PVDF polymer (0.082 g) was added to DMF (1 mL). The PVDF/solvent solution was spun-casted on a glass substrate at 4000 rpm at a relative humidity of 50% to form a film on the glass substrate. The PVDF film had a thickness of 180 nm.
**Comparative Sample C2. Deposition of PVDF on Glass Substrate Using a 60 °C Solution.** A PVDF polymer (0.082 g) was added to DMF (1 mL) and heated to 60 °C to solubilize the PVDF polymer in the solvent. The PVDF/solvent solution was maintained at 60 °C and spun-casted on a glass substrate at 4000 rpm to form a film on the glass substrate. The PVDF film had a thickness of 210 nm.
**Comparative Sample C3. Preparation of a 400 nm Film on a Glass Substrate.** A PVDF polymer (0.097 g) was added to DMF (1 mL) and heated to 100 °C to solubilize the PVDF polymer in the solvent. The PVDF/solvent solution was maintained at 100 °C and spun-casted on a glass substrate at 4000 rpm at a relative humidity of 50% to form a film on the glass substrate. The PVDF film had a thickness of 450 nm.
**Comparative Sample C4. Preparation of a 550 nm Film on a Glass Substrate.** A PVDF polymer (1.04 g) was added to DMF (1 mL) and heated to 100 °C to solubilize the PVDF polymer in the solvent. The PVDF/solvent solution was maintained at 100 °C and spun-casted on a glass substrate at 4000 rpm at a relative humidity of 50% to form a film on the glass substrate. The PVDF film had a thickness of 550 nm.
**Comparative Sample C5. Preparation of a 650 nm Film on a Glass Substrate.** A PVDF polymer (1.13 g) was added to DMF (1 mL) and heated to 100 °C to solubilize the PVDF polymer in the solvent. The PVDF/solvent solution was maintained at 100 °C and spun-casted on a glass substrate at 4000 rpm at a relative humidity of 50% to form a film on the glass substrate. The PVDF film had a thickness of 650 nm.
**Comparative Sample C6. Preparation of an 850 nm Film on a Glass Substrate.** A PVDF polymer (1.36 g) was added to DMF (1 mL) and heated to 100 °C to solubilize the PVDF polymer in the solvent. The PVDF/solvent solution was maintained at 100 °C and spun-casted on a glass substrate at 4000 rpm at a relative humidity of 50% to form a film on the glass substrate. The PVDF film had a thickness of 850 nm.

### Example 3

### (Testing of Films on Glass Substrate)

Samples A-C were analyzed for optical transparency and surface roughness. Optical transparency was determined by visual inspection of a logo as seen through Samples 1-3 and using UV-visible absorption spectroscopy.

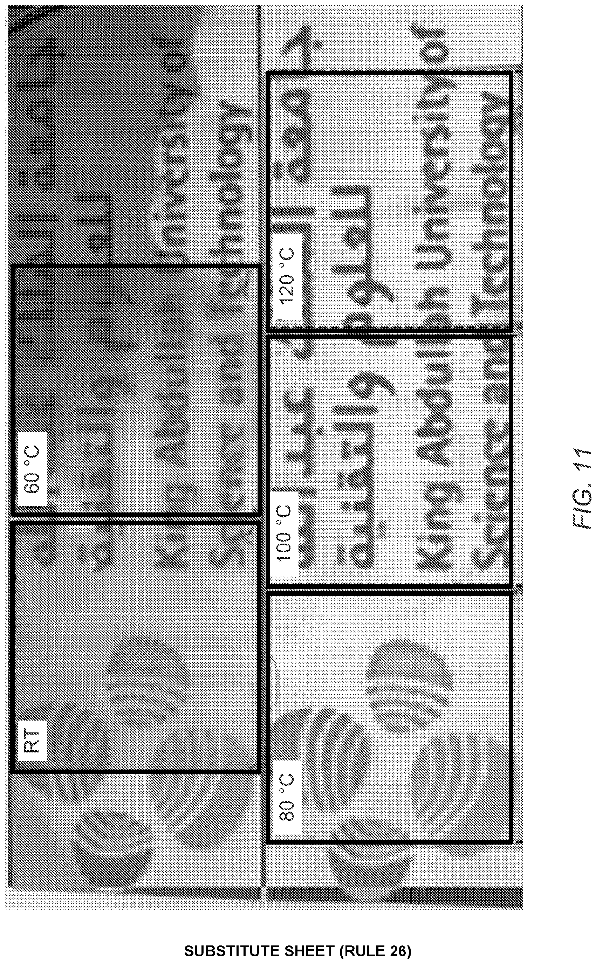

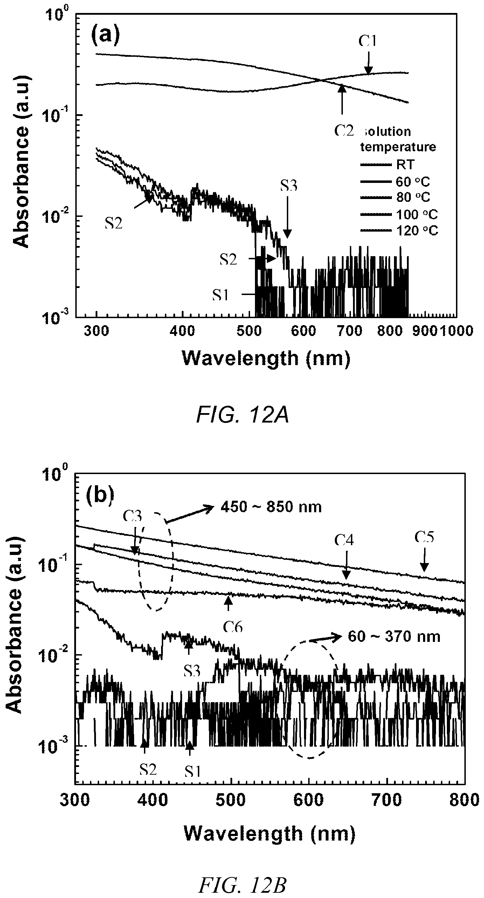

**Optical Transparency.** FIG. 11 depict optical images of a material having the King Abdullah University Science and Technology (KAUST) logo in English and Arabic as viewed through the Samples 1-3. FIGS. 12A and 12B are graphs absorbance (a.u.) versus wavelength (nm) on a double logarithmic scale of Samples 1-3 and Comparative samples C1-C3. As shown in FIG. 11, the symbols and words of the KAUST logo were sharper and had more clarity for Samples 1-3 as compared to Comparative samples C1 and C2 (data lines C1 at room temperature, data line C1 at 60 °C). Referring to FIG. 12A, Samples 1-3 (data lines S1 at 80 °C, S2 at 100 °C, and S3 at 120 °C) had an absorbance of less than 10⁻¹ a.u, and demonstrated interference fringes between 300 and 1000 nm. The majority of the absorbance (between 500 and 850 nm) was less than 10⁻¹ a.u, which demonstrated that these films are extremely smooth as any interference effect is readily cancelled when the film thickness was not uniform or when the surface was rough. Comparative samples C1 and C2 have an absorbance of between 10 and 10⁻¹ a.u. and did not demonstrate any interference fringes as shown by the smooth lines. Thus, C1 and C2 films had poor optical transparency properties, which was in agreement with the visual testing of the KAUST logo. FIG. 12B are graphs absorbance (a.u.) versus wavelength (nm) on a double logarithmic scale of Samples 1-3 (data lines S1-S3) and Comparative samples C3-C6 (data lines C3-C6). As shown in FIG. 12B, as the thickness of PVDF film was increased to greater than 400 nm, the films demonstrated absorbance rather than interference fringes, and thus produced films having poor (cloudy) optical properties.

Surface Roughness. Surface roughness of Samples 1 through 3 were determined using UV-visible absorption and Scanning Electron Microscopic techniques. The films were too thin and smooth to quantify by AFM techniques. FIG. 13 are scanning electron microscopy images of Samples 1-3 ((C-E, respectively) and Comparative samples C1 and C2 (A-B, respectively). Samples 1-3 had a scale bar of 20 microns and samples had a scale bar of 100 micron. As shown in FIG. 13, Samples 1-3 films had smooth surfaces with small to no cracks in the surfaces (undetectable amount of differences in gray and black colors in the image). Comparatives samples C1 and C2 had large voids in the surface (gray area between darker areas) and distinct particle shapes (dark areas).

As shown in FIGS. 12 and 13, Samples 1-3 prepared using the methods of the present invention produced smoother thin films and more optically transparent film as compared to conventional thin films (Comparative samples C1 and C2). Additionally, Samples 1-3 prepared using the methods of the present invention produced films that were more optically transparent as compared to thicker films (Comparative sample C3) prepared at the same temperature.

### Example 4

### (Ferroelectric Films on a Silicon/Platinum Substrate)

**Samples 4-6. Deposition of PVDF on Silicon/Platinum Substrate.** Samples 4-6 were made using the same method as Samples 1-3 except a Silicon/Platinum substrate was used instead of a glass substrate. Sample 4 had a PVDF film thickness 250 nm, sample 5 had a PVDF film thickness of 320 nm, and sample 6 had a PVDF film thickness of 340 nm.

### Example 5

### (Comparative Examples of Ferroelectric Films on a Silicon/Platinum Substrate)

**Comparative Sample C7. Deposition of PVDF on Silicon/Platinum Substrate Using a Room Temperature Solution.** A PVDF polymer (0.82 g) was added to DMF (1 mL). The room temperature PVDF/solvent solution was spun-cast at room temperature on a silicon/platinum (Si/Pt) substrate at 4000 rpm at a relative humidity of 50% to form a film on the Si/Pt substrate. The PVDF film had a thickness about 1000 nm, however, inspection by SEM showed that there were many voids (empty spaces) in the film.

**Comparative Sample C8. Deposition of PVDF on Silicon/Platinum Substrate Using a Room Temperature Solution.** A PVDF polymer (0.82 g) was added to DMF (1 mL) and heated to 60 °C to solubilize the PVDF polymer in the solvent. The PVDF/solvent solution was maintained at 60 °C and spun-casted on a silicon/platinum (Si/Pt) substrate at 4000 rpm at a relative humidity of 50% to form a film on the Si/Pt substrate. The film had a thickness of about 1000 nm, however, inspection by SEM showed that there were many voids (empty spaces) in the film.

### Example 6

### (Testing of Ferroelectric Films on Si/Pt substrate)

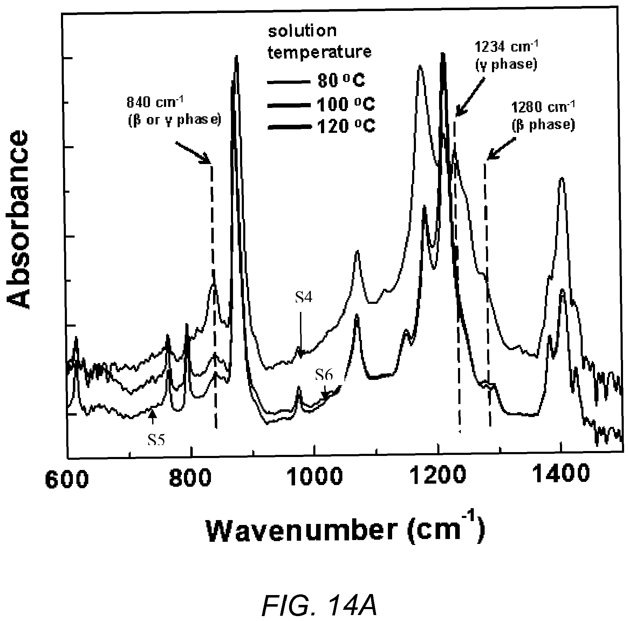

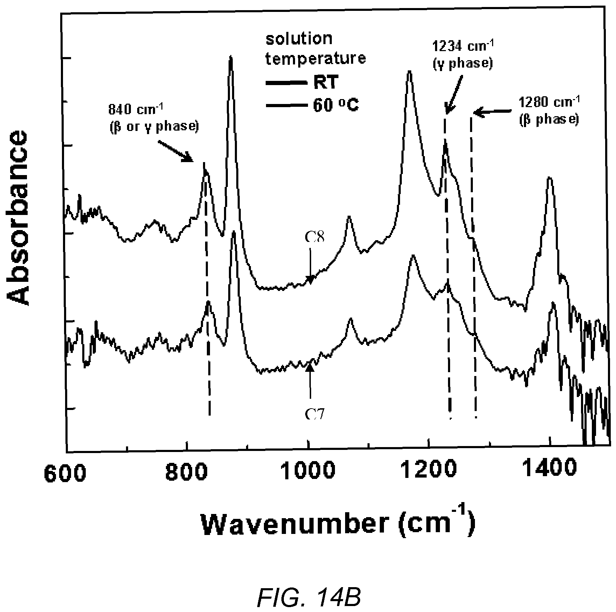

**Fourier Transform Infrared Spectroscopy (FT-IR).** Samples 4-6 and Comparative samples C7 and C8 were analyzed using FT-IR spectroscopy. FIGS. 14A and 14B are graphs of absorbance versus wavenumber (cm⁻¹) of Samples 4-6 (data lines S4-S6 in FIG. 14A) and C7 and C8 (data lines C7 and C8 in FIG. 14B), respectively. All the spectra shows the ferroelectric characteristic peak (840, 1234, 1280 cm-¹).

### Example 7

### (Ferroelectric Device)

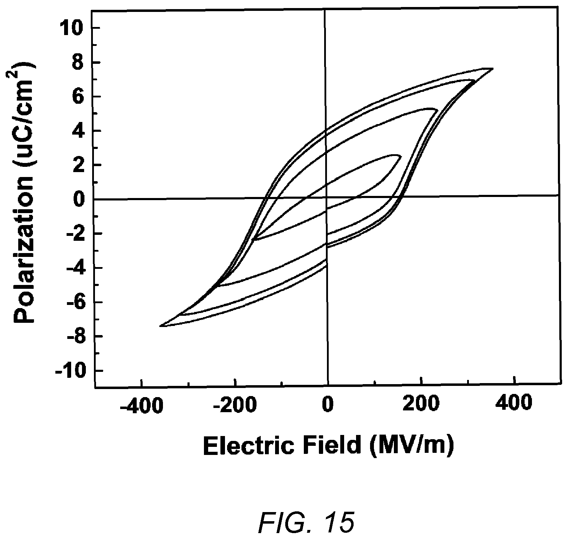

**A Ferroelectric device was made using Sample 6.** The fabricated device had the follow structure; an Au top electrode (90 nm) / PVDF thin film (250 nm) / Pt (bottom electrode) / Ti (5 nm)/ SiO₂ (100 nm) / Si substrate. The representative hysteresis loops were collected, and are summarized in FIG. 15. The remnant polarization and coercive field were 3.9 uC/cm² and 145 MV/m, respectively.

## Claims

1. A method for preparing a ferroelectric film having ferroelectric hysteresis properties, the method comprising:
(a) obtaining a composition comprising a solvent and an organic ferroelectric polymer solubilized therein;
(b) heating the composition to a temperature above 75°C and below the boiling point of the solvent;
(c) depositing the heated composition onto a substrate; and
(d) annealing the heated composition to form a ferroelectric film having ferroelectric hysteresis properties and a thickness of 400 nm or less.

2. The method of claim 1, wherein the thickness of the ferroelectric film is 350 nm or less.

3. The method of claim 2, wherein the composition is heated to above 75 °C to 200 °C.

4. The method of claim 1, wherein the film has a surface roughness of 20 nm or less as determined by Atomic Force Microscopy (AFM).

5. The method of claim 1, wherein the substrate comprises a lower electrode, and wherein the heated solution is deposited on the lower electrode.

6. The method of claim 5, further comprising depositing an upper electrode on the ferroelectric film.

7. The method of claim 1, wherein the solvent comprises dimethylformamide, dimethyl acetate, dimethylacetamide, tetramethyl urea, dimethyl sulfoxide, trimethyl phosphate, N-methyl-2-pyrrolidone, diethyl carbonate, or any combination thereof.

8. The method of claim 1, wherein depositing the composition in step (c) is performed at a relative humidity of 50% or less.

9. The method of claim 1, wherein the film has an absorbance between the wavelengths of 300 to 1000 nm of 10⁻¹ a.u. or less.

10. The method of claim 1, wherein the organic ferroelectric polymer is a polyvinylidene fluoride (PVDF)-based polymer, a polyundecanoamide (Nylon 11)-based polymer, or a blend thereof.

11. The method of claim 10, wherein the PVDF-based polymer is blended with a non-PVDF-based polymer, wherein the non-PVDF polymer is a poly(phenylene oxide) (PPO) polymer, a polystyrene (PS) polymer, or a poly(methyl methacrylate) (PMMA) polymer, or a blend thereof.

12. The method of claim 1, wherein steps (a) through (c) are performed in 60 minutes or more.

13. The method of claim 1, wherein the temperature of the substrate is 80 °C or less, 50 °C or less, 30 °C or less, or at ambient temperature.

14. The method of claim 1, wherein the substrate is not heated during step (b).

15. A ferroelectric film having ferroelectric hysteresis properties, the film comprising an organic ferroelectric polymer, a thickness of 400 nm or less, and the film having a surface roughness of 20 nm or less as determined by Atomic Force Microscopy (AFM) and an absorbance between the wavelengths of 300 to 1000 nm of 10⁻¹ a.u. or less when plottet in double logarithmic scale.

## Patentansprüche

1. Ein Verfahren zur Herstellung eines ferroelektrischen Films mit ferroelektrischen Hysterese-Eigenschaften, das Verfahren umfassend
(a) Erhalten einer Zusammensetzung, umfassend ein Lösungsmittel und ein darin gelöstes organisches ferroelektrisches Polymer;
(b) Erwärmen der Zusammensetzung auf eine Temperatur über 75 °C und unter dem Siedepunkt des Lösungsmittels;
(c) Aufbringen der erhitzten Zusammensetzung auf ein Substrat; und
(d) Tempern der erhitzten Zusammensetzung, um einen ferroelektrischen Film mit ferroelektrischen Hysterese-Eigenschaften und einer Dicke von 400 nm oder weniger zu bilden.

2. Das Verfahren nach Anspruch 1, wobei die Dicke des ferroelektrischen Films 350 nm oder weniger beträgt.

3. Das Verfahren nach Anspruch 2, wobei die Zusammensetzung auf über 75 °C bis 200 °C erhitzt wird.

4. Das Verfahren nach Anspruch 1, wobei der Film eine Oberflächenrauheit von 20 nm oder weniger aufweist, bestimmt durch Atomkraftmikroskopie (AFM).

5. Das Verfahren nach Anspruch 1, wobei das Substrat eine untere Elektrode aufweist, und wobei die erhitzte Lösung auf die untere Elektrode aufgetragen wird.

6. Das Verfahren nach Anspruch 5, ferner umfassend das Auftragen einer oberen Elektrode auf den ferroelektrischen Film.

7. Das Verfahren nach Anspruch 1, wobei das Lösungsmittel Dimethylformamid, Dimethylacetat, Dimethylacetamid, Tetramethylharnstoff, Dimethylsulfoxid, Trimethylphosphat, N-Methyl-2-pyrrolidon, Diethylcarbonat oder eine beliebige Kombination davon umfasst.

8. Das Verfahren nach Anspruch 1, wobei das Aufbringen der Zusammensetzung in Schritt (c) bei einer relativen Feuchtigkeit von 50% oder weniger erfolgt.

9. Das Verfahren nach Anspruch 1, wobei der Film ein Absorptionsvermögen zwischen den Wellenlängen von 300 bis 1000 nm von 10⁻¹ a.u. oder weniger aufweist.

10. Das Verfahren nach Anspruch 1, wobei das organische ferroelektrische Polymer ein Polymer auf Polyvinylidenfluorid (PVDF)-Basis, ein Polymer auf Polyundecanamid-Basis (Nylon 11) oder eine Mischung davon ist.

11. Das Verfahren nach Anspruch 10, wobei das PVDF-basierte Polymer mit einem nicht auf PVDF-basierten Polymer gemischt ist, wobei das nicht auf PVDF-basierte Polymer ein Poly(phenylenoxid) (PPO) Polymer, ein Polystyrol (PS) Polymer, oder ein Polymethylmethacrylat (PMMA) Polymer, oder eine Mischung davon ist.

12. Das Verfahren nach Anspruch 1, wobei die Schritte (a) bis (c) in 60 Minuten oder mehr durchgeführt werden.

13. Das Verfahren nach Anspruch 1, wobei die Temperatur des Substrats 80 °C oder weniger, 50 °C oder weniger, 30 °C oder weniger oder bei Umgebungstemperatur ist.

14. Das Verfahren nach Anspruch 1, wobei das Substrat während Schritt (b) nicht erhitzt wird.

15. Ein ferroelektrischer Film mit ferroelektrischen Hysterese-Eigenschaften, der Film umfassend ein organisches ferroelektrisches Polymer, eine Dicke von 400 nm oder weniger, wobei der Film eine Oberflächenrauheit von 20 nm oder weniger, bestimmt durch Atomkraftmikroskopie (AFM), und ein Absorptionsvermögen zwischen den Wellenlängen von 300 bis 1000 nm von 10⁻¹ a.u. oder weniger, wenn auf doppelt logarithmischer Skala aufgetragen, aufweist.

## Revendications

1. Procédé pour préparer un film ferroélectrique ayant des propriétés d'hystérésis ferroélectrique, le procédé comprenant :
(a) l'obtention d'une composition comprenant un solvant et un polymère ferroélectrique organique solubilisé dans celui-ci ;
(b) le chauffage de la composition à une température supérieure à 75 °C et inférieure au point d'ébullition du solvant ;
(c) le dépôt de la composition chauffée sur un substrat ; et
(d) le recuit de la composition chauffée pour former un film ferroélectrique ayant des propriétés d'hystérésis ferroélectrique et une épaisseur de 400 nm ou moins.

2. Procédé selon la revendication 1, dans lequel l'épaisseur du film ferroélectrique est de 350 nm ou moins.

3. Procédé selon la revendication 2, dans lequel la composition est chauffée au-dessus de 75 °C à 200 °C.

4. Procédé selon la revendication 1, dans lequel le film présente une rugosité de surface de 20 nm ou moins telle que déterminée par microscopie à force atomique (AFM).

5. Procédé selon la revendication 1, dans lequel le substrat comprend une électrode inférieure, et dans lequel la solution chauffée est déposée sur l'électrode inférieure.

6. Procédé selon la revendication 5, comprenant en outre le dépôt d'une électrode supérieure sur le film ferroélectrique.

7. Procédé selon la revendication 1, dans lequel le solvant comprend du diméthylformamide, de l'acétate de diméthyle, du diméthylacétamide, de l'urée de tétraméthyle, du sulfoxyde de diméthyle, du phosphate de triméthyle, du N-méthyl-2-pyrrolidone, du diéthylcarbonate, ou toute combinaison de ceux-ci.

8. Procédé selon la revendication 1, dans lequel le dépôt de la composition à l'étape (c) est effectué à une humidité relative de 50 % ou moins.

9. Procédé selon la revendication 1, dans lequel le film a un pouvoir d'absorption entre les longueurs d'onde de 300 à 1000 nm de 10⁻¹ a.u. ou moins.

10. Procédé selon la revendication 1, dans lequel le polymère ferroélectrique organique est un polymère à base de fluorure de polyvinylidène (PVDF), un polymère à base de polyundécanamide (Nylon 11), ou un mélange de ceux-ci.

11. Procédé selon la revendication 10, dans lequel le polymère à base de fluorure de PVDF est mélangé à un polymère non à base de PVDF, dans lequel le polymère non-PVDF est un polymère de poly(phénylène oxyde) (PPO), un polymère de polystyrène (PS), ou un polymère de poly(méthyle méthacrylate) (PMMA), ou un mélange de ceux-ci.

12. Procédé selon la revendication 1, dans lequel les étapes (a) à (c) sont effectuées en 60 minutes ou plus.

13. Procédé selon la revendication 1, dans lequel la température du substrat est de 80 C ou moins, de 50 °C ou moins, de 30 °C ou moins, ou à température ambiante.

14. Procédé selon la revendication 1, dans lequel le substrat n'est pas chauffé durant l'étape (b).

15. Film ferroélectrique ayant des propriétés d'hystérésis ferroélectrique, le film comprenant un polymère ferroélectrique organique, une épaisseur de 400 nm ou moins, et le film ayant une rugosité de surface de 20 nm ou moins telle que déterminée par microscopie à force atomique (AFM), et un pouvoir d'absorption entre les longueurs d'onde de 300 à 1000 nm de 10⁻¹ a.u. ou moins quand il est tracé sur une double échelle logarithmique.
